(19) Europäisches Patentamt
European Patent Office
Office européen des brevets

(11) EP 3 438 222 B1

(12) **EUROPEAN PATENT SPECIFICATION**

(45) Date of publication and mention of the grant of the patent:
**04.05.2022 Bulletin 2022/18**

(21) Application number: **17774527.0**

(22) Date of filing: **21.03.2017**

(51) International Patent Classification (IPC):
***C09K 3/10*** $^{(2006.01)}$ ***H01G 9/20*** $^{(2006.01)}$
***H01L 51/42*** $^{(2006.01)}$ ***C08F 2/50*** $^{(2006.01)}$

(52) Cooperative Patent Classification (CPC):
(C-Sets available)
**C09K 3/10; C08F 2/50; H01G 9/20; H01L 51/42;**
C08F 2810/20; Y02E 10/542; Y02E 10/549 (Cont.)

(86) International application number:
**PCT/JP2017/011247**

(87) International publication number:
**WO 2017/169986 (05.10.2017 Gazette 2017/40)**

(54) **PHOTOCURABLE SEALANT COMPOSITION, COMMODITY, AND ORGANIC SOLAR CELL**

LICHTHÄRTBARE DICHTUNGSZUSAMMENSETZUNG, ROHSTOFF UND ORGANISCHE SOLARZELLE

COMPOSITION DE MATÉRIAU D’ÉTANCHÉITÉ PHOTODURCISSABLE, PRODUIT ET CELLULE SOLAIRE ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.03.2016 JP 2016069196**

(43) Date of publication of application:
**06.02.2019 Bulletin 2019/06**

(73) Proprietor: **Zeon Corporation**
**Tokyo 100-8246 (JP)**

(72) Inventors:
- **YOSHIWARA, Akihiko**
  **Tokyo 100-8246 (JP)**
- **KOJIMA, Kiyoshige**
  **Tokyo 100-8246 (JP)**
- **MATSUO, Takatoshi**
  **Tokyo 100-8246 (JP)**

(74) Representative: **Hansen, Norbert**
**Maiwald Patentanwalts- und Rechtsanwaltsgesellschaft mbH**
**Elisenhof**
**Elisenstraße 3**
**80335 München (DE)**

(56) References cited:
**WO-A1-2009/050995**
**WO-A1-2011/052747**
**WO-A1-2014/061267**
**WO-A1-2014/136667**
**WO-A1-2015/111635**
**JP-A- 2010 198 932**
**JP-A- 2015 021 059**
**JP-A- 2015 079 239**
**JP-B2- 5 693 799**
**US-A1- 2013 288 021**

EP 3 438 222 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
C08F 210/06;
C08F 222/102

## Description

### TECHNICAL FIELD

The disclosure relates to a photocurable sealant composition, an article such as an organic solar cell.

### BACKGROUND

In organic solar cells such as dye-sensitized solar cells or perovskite solar cells, sealants are used for the encapsulation of electrolyte solutions.

The sealants are required to have excellent adhesiveness to a substrate (electrode substrate). Also, the sealants are required to have high reliability, i.e., low reactivity with an electrolyte. High reactivity with an electrolyte solution facilitates swelling or deteriorating the sealants due to the electrolyte solution, leading to reduction in photoelectric conversion efficiency or leakage of the electrolyte solution.

A cross-linkable rubber composition described in PTL 1 contains an ethylene-$\alpha$-olefin-non-conjugated polyene random copolymer (A) and a hydrosilyl group-containing compound (B) in combination. This rubber composition has a low degree of cross-linking, low adhesiveness, and a thermosetting property. Therefore, use of this rubber composition in sealing requires heating for the sealing. Hence, solar cells might be deteriorated due to low adhesiveness or heating.

PTL 2 discloses a sealant composition for dye-sensitized solar cells comprising (A) a hydrogenated polybutadiene compound having a (meth)acryl group. However, this sealant composition has poor reliability.

PTL 3 discloses a photoelectric conversion element comprising a polyisobutylene resin-based sealant. However, this polyisobutylene resin-based sealant causes cure shrinkage during sealing and has poor adhesiveness.

### CITATION LIST

#### Patent Literature

PTL 1: JP2015-134937A
PTL 2: JP2010-180258A
PTL 3: WO2007/046499A

### SUMMARY

#### (Technical Problem)

FIG. 3 is a schematic diagram showing one example of an organic solar cell module having a general series structure (Z type). In organic solar cell module 100 having a series structure, shown in FIG. 3, photoelectrode substrate 101 and counter electrode substrate 102 are disposed to face each other. Conductive layer 104 is provided on substrate 103. Titanium oxide layer (porous semiconductor fine particle layer) 105 is disposed with a predetermined pattern on the photoelectrode substrate 101. Catalyst layer 106 is disposed on the counter electrode substrate 102. Further, conductive connection material 107 which establishes the conduction between the photoelectrode and the counter electrode, and sealant 108 for the adhesion between the photoelectrode substrate 101 and the counter electrode substrate 102 are disposed peripherally in the titanium oxide layer 105. A laser cut-insulated part of the conductive layer 104 on the substrate 103 is filled with the sealant 108. Electrolyte solution 109 is encapsulated in a space surrounded by the photoelectrode substrate 101, the counter electrode substrate 102 and the sealant 108. In all the drawings of the present application, a sensitizing dye layer on the titanium oxide layer is omitted in order to simplify description. In all the drawings of the present application, each member is schematically shown, and the dimension, shape, interval of disposition, etc. of each member are not always correctly drawn.

Procedures for producing the organic solar cell module 100 having a series structure, shown in FIG. 3, by one drop filling (ODF) are, for example, as follows: first, titanium oxide layer 105 is formed on photoelectrode substrate 101. Subsequently, a dye is adsorbed onto the titanium oxide layer 105 to form a sensitizing dye layer. Subsequently, a conductive part of the titanium oxide layer 105 is coated with a sealant composition containing conductive connection material (gold-plated particles, etc.) 107 to form sealant 108. Subsequently, a pattern part of the titanium oxide layer 105 is coated with electrolyte solution 109 in vacuum. Subsequently, counter electrode substrate 102 with catalyst layer 106 formed thereon is bonded to the photoelectrode substrate 101 such that the catalyst layer 106 and the titanium oxide layer 105 face each other. Platinum films, which may be used as the catalyst layer 106, partially filter out light.

Also, carbon nanostructures, such as carbon nanotubes, which have been adopted as the catalyst layer 106 in recent years, usually have lower light transmittance than that of the platinum films. Hence, after the bonding, the sealant composition is cured by light irradiation from the photoelectrode substrate 101 side to obtain the organic solar cell module 100.

FIG. 4 is a schematic diagram showing one example of an enlarged view of a sealant composition part immediately before curing of the sealant composition by light irradiation. In order to secure contact or conduction with the counter electrode substrate 102, a sealant composition containing the conductive connection material 107 (conductive resin composition) is applied to between the photoelectrode substrate 101 and the counter electrode substrate 102. The conductive connection material 107 has a light blocking effect. Therefore, when this organic solar cell module before light irradiation is irradiated with light from the photoelectrode substrate 101 side, a part on a side opposite to the photoelectrode substrate 101, of the conductive connection material 107 becomes light blocking part 110 as shown in FIG. 4 so the sealant composition at the light blocking part 110 is irradiated with a decreased amount of light or not irradiated. Hence, the sealant composition at the light blocking part 110 is insufficiently photocured, disadvantageously resulting in poor curing or longer curing time of the sealant composition.

A polyethylene naphthalate (PEN) film or UV-cut glass impermeable to ultraviolet light (UV) of 300 nm or lower may be used as an electrode substrate. In such a case as well, the sealant composition is insufficiently photocured, and problems such as poor curing of the sealant composition arise as described above.

Accordingly, an object of the disclosure is to provide a photocurable sealant composition capable of forming a sealant that exerts sufficient photocurability even at a light blocking part, is excellent in adhesiveness to a substrate, and has highly reliable sealing performance. Another object of the disclosure is to provide an article comprising a sealant having highly reliable sealing performance. A further object of the disclosure is to provide an organic solar cell having high reliability.

(Solution to Problem)

The photocurable sealant composition according to the disclosure is a photocurable sealant composition comprising:

(A) a liquid rubber, being in a liquid state at 23°C;
(B) a (meth)acryloyl group-containing compound;
(C) an aromatic sensitization aid capable of absorbing light having a wavelength of 300 nm or higher; and
(D) a photopolymerization initiator,

wherein the component (D) comprises two or more photopolymerization initiators differing in absorption wavelength;
wherein the component (A) is a liquid polymer having a cyclic olefin structure or a liquid saturated elastomer; and
wherein the liquid saturated elastomer is at least one member selected from the group consisting of hydrogenated polybutadiene, hydrogenated polyisoprene, a hydrogenated butadiene-isoprene copolymer and polyisobutylene.

The composition thus configured can form a sealant that exerts sufficient photocurability even at a light blocking part, is excellent in adhesiveness to a substrate, and has highly reliable sealing performance.

For the photocurable sealant composition according to the disclosure, it is preferred that an SP value of the component (A) should be 6 to 9. This enhances electrolyte solution resistance and resistance to invasion by water, deterioration ascribable to oxygen, etc. The resulting sealant is excellent in reliability and close adherence.

For the photocurable sealant composition according to the disclosure, it is preferred that the component (A) should be an ethylene-propylene terpolymer copolymer or a liquid saturated elastomer.

For the photocurable sealant composition according to the disclosure, it is preferred that the photocurable sealant composition should comprise 10 to 200 parts by mass of the component (B) per 100 parts by mass of the component (A). This increases the degree of cross-linking of a resin and is effective for achieving all of close adherence to a substrate, electrolyte resistance, and the coating property of a sealant.

For the photocurable sealant composition according to the disclosure, the component (D) comprises two or more photopolymerization initiators differing in absorption wavelength. This can allow the photocurable sealant composition to be gelled early and subsequently be cured mainly.

The photocurable sealant composition according to the disclosure can also be suitably used when a substrate to which the photocurable sealant composition is applied is an organic resin.

The article according to the disclosure is an article selected from the group consisting of a solar cell, a display, an electronic component, a coating material and an adhesive, comprising a cured product of any of the photocurable sealant compositions described above. The article comprising such a cured product has high reliability.

Further described herein is an organic solar cell comprising:

a first electrode substrate;
a second electrode substrate;
a light blocking member; and
a sealant, wherein
the first electrode substrate and the second electrode substrate are disposed to face each other,
the first electrode substrate has two surfaces, a first surface and a second surface,
the first surface of the first electrode substrate faces the second electrode substrate,
the second surface of the first electrode substrate is a light incident surface,
the light blocking member is disposed on the first surface of the first electrode substrate, and
the sealant is positioned at least at a light blocking part on a side opposite to the light incident surface side, of the light blocking member. The organic solar cell comprising such a cured product has high reliability.

The organic solar cell can also be suitably used when the first electrode substrate filters out 50% or more of a wavelength of 300 nm or lower.

For the organic solar cell, it is preferred that the sealant should be a cured product of a photocurable sealant composition comprising an aromatic sensitization aid capable of absorbing light having a wavelength of 300 nm or higher. This enhances the reliability of the sealant at the light blocking part.

(Advantageous Effect)

The disclosure can provide a photocurable sealant composition capable of forming a sealant that exerts sufficient photocurability even at a light blocking part, is excellent in adhesiveness to a substrate, and has highly reliable sealing performance. The disclosure can provide an article comprising a sealant having highly reliable sealing performance.

BRIEF DESCRIPTION OF THE DRAWINGS

In the accompanying drawings:

FIG. 1 is a schematic cross-sectional view of one example of the organic solar cell according to the disclosure;
FIG. 2 is a schematic cross-sectional view of another example of the organic solar cell according to the disclosure;
FIG. 3 is a schematic cross-sectional view of one example of a general organic solar cell; and
FIG. 4 is an enlarged view of the schematic cross-sectional view of one example of the general organic solar cell.

DETAILED DESCRIPTION

Hereinafter, embodiments of the disclosure will be described. The description below is intended to illustrate the disclosure and does not limit the disclosure by any means.

In the present specification, a numeric range intends to include a lower limit value and an upper limit value of the range unless otherwise specified. For example, 10 to 200 parts by mass intend to include the lower limit value of 10 parts by mass and the upper limit value of 200 parts by mass and mean 10 parts by mass or more and 200 parts by mass or less.

(Photocurable sealant composition)

The photocurable sealant composition according to the disclosure is a photocurable sealant composition (hereinafter, also simply referred to as a "sealant composition") comprising:

(A) a liquid rubber, being in a liquid state at 23°C;
(B) a (meth)acryloyl group-containing compound;
(C) an aromatic sensitization aid capable of absorbing light having a wavelength of 300 nm or higher; and
(D) a photopolymerization initiator

wherein the component (D) comprises two or more photopolymerization initiators differing in absorption wavelength;
wherein the component (A) is a liquid polymer having a cyclic olefin structure or a liquid saturated elastomer; and
wherein the liquid saturated elastomer is at least one member selected from the group consisting of hydrogenated polybutadiene, hydrogenated polyisoprene, a hydrogenated butadiene-isoprene copolymer and polyisobutylene.

The sealant composition thus configured can form a sealant that exerts sufficient photocurability even at a light blocking

part, is excellent in adhesiveness to a substrate, and has highly reliable sealing performance.

<Component (A)>

The component (A) is a liquid rubber. The liquid rubber refers to a rubber that is in a liquid state at 23°C.

The component (A) is not particularly limited as long as the component (A) is a liquid rubber having a cyclic olefin structure or a liquid saturated elastomer; and wherein the liquid saturated elastomer is at least one member selected from the group consisting of hydrogenated polybutadiene, hydrogenated polyisoprene, a hydrogenated butadiene-isoprene copolymer and polyisobutylene. A liquid rubber known in the art can be used. Examples thereof include liquid polymers having a cyclic olefin structure, and liquid saturated elastomers as defined in claim 1.

Examples of the liquid polymer having a cyclic olefin structure include liquid polymers having a norbornene structure.

The liquid polymer having a cyclic olefin structure preferably comprises a constitutional unit (i) derived from ethylene, a constitutional unit (ii) derived from an α-olefin having 3 to 20 carbon atoms, and a constitutional unit (iii) derived from at least one non-conjugated polyene selected from a norbornene compound represented by the following general formula (1) and a norbornene compound represented by the following general formula (2):

[Formula 1]

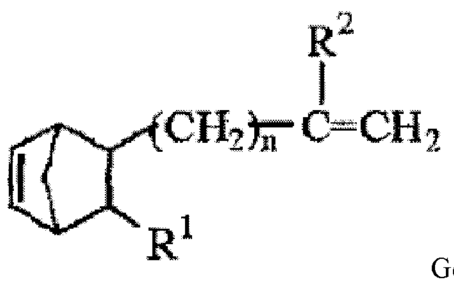

General formula (1)

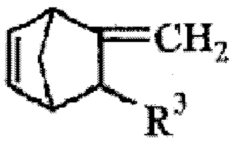

General formula (2)

In the general formula (1), $R^1$ is a hydrogen atom or an alkyl group having 1 to 10 carbon atoms, $R^2$ is a hydrogen atom or an alkyl group having 1 to 5 carbon atoms, and n is an integer of 0 to 10. In the general formula (2), $R^3$ is a hydrogen atom or an alkyl group having 1 to 10 carbon atoms.

Examples of the α-olefin having 3 to 20 carbon atoms constituting the constitutional unit (ii) include propylene, 1-butene, 4-methyl-1-pentene, 1-hexene, 1-heptene, 1-octene, 1-nonene, 1-decene, 1-undecene, 1-dodecene, 1-tridecene, 1-tetradecene, 1-pentadecene, 1-hexadecene, 1-heptadecene, 1-nonadecene, 1-eicosene, 9-methyl-1-decene, 11-methyl-1-dodecene, and 12-ethyl-1-tetradecene. The α-olefin is preferably an α-olefin having 3 to 10 carbon atoms. The α-olefin is more preferably one or more members selected from 1-butene, 1-hexene and 1-octene. The α-olefin having 3 to 20 carbon atoms may be used singly or in combinations of two or more thereof.

The non-conjugated polyene constituting the constitutional unit (iii) is a terminal vinyl group-containing norbornene compound and is at least one member selected from a norbornene compound represented by the general formula (1) and a norbornene compound represented by the general formula (2).

In the general formula (1), n is an integer of 0 to 10. n is preferably an integer of 0 to 5.

In the general formula (1), $R^1$ is a hydrogen atom or an alkyl group having 1 to 10 carbon atoms. Examples of the alkyl group include a methyl group, an ethyl group, a propyl group, an isopropyl group, a n-butyl group, an isobutyl group, a sec-butyl group, a t-butyl group, a n-pentyl group, an isopentyl group, a t-pentyl group, a neopentyl group, a hexyl group, an isohexyl group, a heptyl group, an octyl group, a nonyl group, and a decyl group. $R^1$ is preferably a hydrogen atom, a methyl group or an ethyl group.

In the general formula (1), $R^2$ is a hydrogen atom or an alkyl group having 1 to 5 carbon atoms. Examples of the alkyl group include the alkyl groups having 1 to 5 carbon atoms among the specific examples of $R^1$ described above. $R^2$ is preferably a hydrogen atom, a methyl group or an ethyl group.

In the general formula (2), $R^3$ is a hydrogen atom or an alkyl group having 1 to 10 carbon atoms. Examples of the alkyl group include the alkyl groups listed as $R^1$.

Examples of the norbornene compound represented by the general formula (1) or (2) include 5-methylene-2-norbornene, 5-vinyl-2-norbornene, 5-(2-propenyl)-2-norbornene, 5-(3-butenyl)-2-norbornene, 5-(1-methyl-2-propenyl)-2-norbornene, 5-(4-pentenyl)-2-norbornene, 5-(1-methyl-3-butenyl)-2-norbornene, 5-(5-hexenyl)-2-norbornene, 5-(5-heptenyl)-2-norbornene, 5-(1-methyl-4-pentenyl)-2-norbornene, 5-(2,3-dimethyl-3-butenyl)-2-norbornene, 5-(2-ethyl-3-butenyl)-2-norbornene, 5-(6-heptenyl)-2-norbornene, 5-(3-methyl-5-hexenyl)-2-norbornene, 5-(3,4-dimethyl-4-pentenyl)-2-norbornene, 5-(3-ethyl-4-pentenyl)-2-norbornene, 5-(7-octenyl)-2-norbornene, 5-(2-methyl-6-heptenyl)-2-norbornene, 5-(1,2-dimethyl-5-hexenyl)-2-norbornene, 5-(5-ethyl-5-hexenyl)-2-norbornene, and 5-(1,2,3-trimethyl-4-pentenyl)-2-norbornene. The norbornene compound is preferably one or more members selected from 5-vinyl-2-norbornene, 5-methylene-2-norbornene, 5-(2-propenyl)-2-norbornene, 5-(3-butenyl)-2-norbornene, 5-(4-pentenyl)-2-norbornene, 5-(5-hexenyl)-2-norbornene, 5-(5-heptenyl)-2-norbornene, 5-(6-heptenyl)-2-norbornene and 5-(7-octenyl)-2-norbornene.

As the non-conjugated polyene, the norbornene compounds represented by the general formulas (1) and (2) may be used in combination with an additional non-conjugated polyene, for example, a non-conjugated polyene including: chain non-conjugated dienes such as 1,4-hexadiene, 3-methyl-1,4-hexadiene, 4-methyl-1,4-hexadiene, 5-methyl-1,4-hexadiene, 4,5-dimethyl-1,4-hexadiene, and 7-methyl-1,6-octadiene; cyclic non-conjugated dienes such as methyltetrahydroindene, 5-ethylidene-2-norbornene, 5-isopropylidene-2-norbornene, 5-vinylidene-2-norbornene, 6-chloromethyl-5-isopropenyl-2-norbornene, and dicyclopentadiene; and trienes such as 2,3-diisopropylidene-5-norbornene, 2-ethylidene-3-isopropylidene-5-norbornene, and 2-propenyl-2,2-norbornadiene.

In the case of using the norbornene compounds represented by the general formulas (1) and (2) in combination with the additional non-conjugated polyene, their ratio can be appropriately adjusted and is not particularly limited. For example, the additional non-conjugated polyene is used at usually 50% by mol or less, preferably 40% by mol or less, more preferably 30% by mol or less, further preferably 20% by mol or less, particularly preferably 10% by mol or less, per 100% by mol of the norbornene compounds represented by the general formulas (1) and (2).

The molar ratio between the constitutional unit (i) derived from ethylene and the constitutional unit (ii) derived from an $\alpha$-olefin having 3 to 20 carbon atoms, (i):(ii), can be appropriately adjusted and is not particularly limited. The molar ratio (i):(ii) is usually 35:65 to 95:5, preferably 40:60 to 90:10, more preferably 45:55 to 85:15.

The liquid polymer having a cyclic olefin structure is particularly preferably an ethylene-propylene terpolymer copolymer.

The liquid polymer having a cyclic olefin structure preferably has a low viscosity. Hence, the weight-average molecular weight (Mw) of the liquid polymer having a cyclic olefin structure is preferably 10000 or smaller, more preferably 2000 to 6000.

The iodine value of the liquid polymer having a cyclic olefin structure is not particularly limited and can be appropriately adjusted. The iodine value may be usually 0 to 55 (g/100 g), preferably 5 to 30 (g/100 g), more preferably 10 to 20 (g/100 g). When the iodine value falls within the range described above, reactivity with an electrolyte solution can be reduced and reliability can be enhanced. Also, reactivity with a methacryl compound as the component (B) is favorable.

The method for preparing the liquid polymer having a cyclic olefin structure is not particularly limited, and a method known in the art can be used. The liquid polymer having a cyclic olefin structure can be prepared by, for example, a method described in Shin Porima Seizou Purosesu (New Polymer Production Process in English) (Kogyo Chosakai Publishing Co., Ltd., p. 309-330) or PTL 1. The liquid polymer having a cyclic olefin structure is obtained, for example, by random-copolymerizing ethylene, an $\alpha$-olefin having 3 to 20 carbon atoms, and a non-conjugated polyene under conditions involving a polymerization temperature of 20 to 60°C, a polymerization pressure of 0.4 to 5 MPa, and a molar ratio of the amounts of the non-conjugated polyene and the ethylene supplied (non-conjugated polyene/ethylene) of 0.01 to 0.2 in the presence of a catalyst containing a vanadium compound and an organoaluminum compound as main components.

The liquid polymer having a cyclic olefin structure may be graft-modified with a graft modifying agent. The graft modifying agent may be used singly or in combinations of two or more thereof. Examples of the graft modifying agent include unsaturated carboxylic acids, acid anhydrides of unsaturated carboxylic acids, unsaturated carboxylic acid esters, hydroxyl group-containing ethylenically unsaturated compounds, amino group-containing ethylenically unsaturated compounds, epoxy group-containing ethylenically unsaturated compounds, aromatic vinyl compounds, vinyl ester compounds, and vinyl chloride.

Examples of the unsaturated carboxylic acid as the graft modifying agent include acrylic acid, methacrylic acid, maleic acid, fumaric acid, itaconic acid, citraconic acid, tetrahydrophthalic acid, and bicyclo(2,2,1)hept-2-ene-5,6-dicarboxylic acid.

Examples of the acid anhydride of an unsaturated carboxylic acid as the graft modifying agent include maleic anhydride, itaconic anhydride, citraconic anhydride, tetrahydrophthalic anhydride, and bicyclo(2,2,1)hept-2-ene-5,6-dicarboxylic anhydride.

Examples of the unsaturated carboxylic acid ester as the graft modifying agent include methyl acrylate, ethyl

acrylate, methyl methacrylate, ethyl methacrylate, dimethyl maleate, monomethyl maleate, dimethyl fumarate, dimethyl itaconate, diethyl citraconate, dimethyl tetrahydrophthalate, and dimethyl bicyclo(2,2,1)hept-2-ene-5,6-dicarboxylate.

The amount of the graft modifying agent used is preferably 0.1 mol or less per 100 g of the polymer before graft modification.

The method for graft-modifying the liquid polymer having a cyclic olefin structure (unmodified polymer) is not particularly limited, and a method known in the art can be appropriately selected and used. For example, the unmodified polymer can be reacted with the graft modifying agent in the presence of a radical initiator to obtain a graft-modified polymer.

The radical initiator is not particularly limited and can be appropriately selected and used. Examples thereof include: dialkyl peroxides such as dicumyl peroxide, di-t-butyl peroxide, di-t-butylperoxy-3,3,5-trimethylcyclohexane, t-butylcumyl peroxide, di-t-amyl peroxide, t-butyl hydroperoxide, 2,5-dimethyl-2,5-di(t-butylperoxy)hexine-3,2,5-dimethyl-2,5-di(benzoylper oxy)hexane, 2,5-dimethyl-2,5-di(t-butylperoxy)hexane, and $\alpha,\alpha'$-bis(t-butylperoxy-m-isopropyl)benzene; peroxy esters such as t-butyl peroxy acetate, t-butyl peroxy isobutylate, t-butyl peroxy pivalate, t-butyl peroxy maleic acid, t-butyl peroxy neodecanoate, t-butyl peroxy benzoate, and di-t-butyl peroxy phthalate; ketone peroxides such as dicyclohexanone peroxide; and combinations thereof.

A commercially available product may be used as the liquid polymer having a cyclic olefin structure. Examples of the commercially available product include Mitsui EPT series such as ethylene-propylene terpolymer PX-068 manufactured by Mitsui Chemicals, Inc.

The liquid saturated elastomer is a liquid resin having a saturated backbone. Examples thereof include hydrogenated polybutadiene, hydrogenated polyisoprene, hydrogenated butadiene-isoprene copolymers, and polyisobutylene. The liquid saturated elastomer is at least one member selected from the group consisting of hydrogenated polybutadiene, hydrogenated polyisoprene, a hydrogenated butadiene-isoprene copolymer and polyisobutylene.

The liquid saturated elastomer may or may not have a functional group at a side chain, one end or both ends. Examples of such a terminal functional group include a (meth)acryl group, an epoxy group, an acid anhydride group, a hydroxyl group, and a carboxyl group.

A commercially available product may be used as the liquid saturated elastomer. Examples of the commercially available product include product names SPBDA-30 and SPBDA-S30 manufactured by Osaka Organic Chemical Industry Ltd., GI series, CI series, and BI series belonging to NISSO®-PB hydrogenation PB resins (hydrogenated polybutadienes) manufactured by Nippon Soda Co., Ltd., and (hydrogenated polybutene) HV-300 and HV-300M manufactured by Nippon Oil Corp. Specific examples thereof include: GI series such as GI-1000 (number-average molecular weight = approximately 1500, iodine value = 21 mg/100 g or lower), GI-2000 (number-average molecular weight = approximately 2100, iodine value = 21 mg/100 g or lower, terminal functional group = hydroxyl group), and GI-3000 (number-average molecular weight = approximately 3000, iodine value = 21 mg/100 g or lower); CI series such as CI-1000 (number-average molecular weight = approximately 1400, iodine value = 21 mg/100 g or lower, terminal functional group = carboxyl group); and BI series such as BI-2000 (number-average molecular weight = approximately 2100, iodine value = 21 mg/100 g or lower) and BI-3000 (number-average molecular weight = approximately 3100, iodine value = 21 mg/100 g or lower).

The weight-average molecular weight of the component (A) is preferably 1000 to 10000.

The SP value of the component (A) is preferably 6 to 9. This enhances electrolyte solution resistance and resistance to invasion by water, deterioration ascribable to oxygen, etc. The resulting sealant is excellent in reliability and close adherence. The SP values (unit: $cal/cm^3$) of some of the components (A) mentioned above are as follows:

Fluorine rubber: 7.3
Cycloolefin polymer (COP): 7.4
Polybutadiene: 8.3
Polyisobutylene: 7.8
Polyisoprene: 8.1
Ethylene-propylene terpolymer copolymer: 8
Polyethylene: 8.1
Polystyrene: 8.7
Styrene-butadiene copolymer (SBR): 8.1 to 8.6

The component (A) is particularly preferably an ethylene-propylene terpolymer copolymer or a liquid saturated elastomer.

The component (A) may be used singly or in combinations of two or more thereof.

<Component (B)>

The component (B) is a (meth)acryloyl group-containing compound. Specifically, the component (B) is a compound having an acryloyl group and/or a compound having a methacryloyl group. While not wishing to be bound by any theory, combined use of the component (A) and the component (B) is presumed to increase the degree of cross-linking and improve reliability. When a silane coupling agent for use in the surface treatment of a component (E) mentioned later has a (meth)acryloyl group, the silane coupling agent is not the component (B) and is treated as a silane coupling agent.

The component (B) is not particularly limited and can be appropriately selected and used. Examples thereof include: carboxylic acids such as acrylic acid and methacrylic acid; (meth)acryloyl group-containing compounds having a cyclic ether group, such as glycidyl acrylate, tetrahydrofurfuryl acrylate, glycidyl methacrylate, and tetrahydrofurfuryl methacrylate; monofunctional (meth)acryloyl group-containing compounds having a cyclic aliphatic group such as cyclohexyl acrylate, isobornyl acrylate, dicyclopentenyl acrylate, dicyclopentenyloxyethyl acrylate, dicyclopentanyl acrylate, dicyclopentanylethyl acrylate, 4-tert-butylcyclohexyl acrylate, 1-adamantanyl acrylate, cyclohexyl methacrylate, isobornyl methacrylate, dicyclopentenyl methacrylate, dicyclopentenyloxyethyl methacrylate, dicyclopentanyl methacrylate, dicyclopentanylethyl methacrylate, 4-tert-butylcyclohexyl methacrylate, and 1-adamantanyl methacrylate; oxetane group-containing compounds such as (3-ethyloxetan-3-yl)methyl acrylate and (3-ethyloxetan-3-yl)methyl methacrylate; dioxolane group-containing compounds such as (2-methyl-2-ethyl-1,3-dioxolan-4-yl)methyl acrylate; monofunctional (meth)acryloyl group-containing compounds having a chain aliphatic group, such as lauryl acrylate, isononyl acrylate, 2-ethylhexyl acrylate, isobutyl acrylate, tert-butyl acrylate, isooctyl acrylate, isoamyl acrylate, lauryl methacrylate, isononyl methacrylate, 2-ethylhexyl methacrylate, isobutyl methacrylate, tert-butyl methacrylate, isooctyl methacrylate, and isoamyl methacrylate; monofunctional (meth)acryloyl group-containing compounds having an aromatic ring, such as benzyl acrylate, phenoxyethyl acrylate, benzyl methacrylate, phenoxyethyl methacrylate, 2-hydroxy-3-phenoxypropyl methacrylate, and phenol EO-modified acrylate; phthalimide-containing compounds such as N-acryloyloxyethyl hexahydrophthalimide; isocyanuric acid-containing compounds such as ethoxylated isocyanuric acid triacrylate, ε-caprolactone-modified tris-(2-acryloxyethyl)isocyanurate, and isocyanuric acid EO-modified di- and triacrylates; and polyfunctional (meth)acryloyl group-containing compounds such as polyethylene glycol diacrylate, decanediol diacrylate, nonanediol diacrylate, hexanediol diacrylate, tricyclodecane dimethanol diacrylate, trimethylolpropane triacrylate, pentaerythritol triacrylate, pentaerythritol tetraacrylate, dipentaerythritol pentaacrylate, and dipentaerythritol hexaacrylate.

The component (B) preferably comprises a compound having a carboxyl group or an acid anhydride group.

The weight-average molecular weight of the component (B) is preferably smaller than 1000.

The amount of the component (B) is not particularly limited and can be appropriately adjusted. The sealant composition preferably comprises 10 to 200 parts by mass of the component (B) per 100 parts by mass of the component (A).

<Component (C)>

The component (C) is an aromatic sensitization aid capable of absorbing light having a wavelength of 300 nm or higher. The sealant composition containing such a component (C) is easily photocured even at a light blocking part.

The component (C) is not particularly limited as long as the component (C) is an aromatic compound capable of absorbing light having a wavelength of 300 nm or higher. Examples of the component (C) include anthracene compounds, coumarin compounds, carbazole compounds, benzoxazole compounds, naphthalene compounds such as naphthalene and naphthalene halide, stilbene compounds, benzidine compounds, pyrene compounds, perylene compounds, naphthalimide compounds, and benzotriazole compounds. Such a compound for use as the component (C) absorbs light having a wavelength of 300 nm or higher and causes energy transfer, electron transfer, or the like. Therefore, the sufficient curing of the sealant composition is presumably achieved even at a light blocking part where sufficient light irradiation is not obtained by light irradiation in one direction. Among others, the component (C) is preferably an anthracene compound, a carbazole compound, or a naphthalene compound, more preferably an anthracene compound. Examples thereof include substituted anthracene compounds having one or more groups selected from a -OR group, a -OC(O)OR group and a combination thereof (R is an alkyl group having 1 to 12 carbon atoms, an allyl group or an aryl group having 6 to 12 carbon atoms) at position 9 or positions 9 and 10 of the anthracene ring. In the case of having the substituents at positions 9 and 10 of the anthracene ring, these substituents may be the same or may be different.

The substituted anthracene compound is, for example, a 9-substituted anthracene compound when having a -OR group at position 9, and is a 9-alkoxyanthracene compound when R is an alkyl group. The substituted anthracene compound is, for example, a 9,10-disubstituted anthracene compound when having -OR groups at positions 9 and 10, and is a 9,10-dialkoxyanthracene compound when R is an alkyl group.

The substituted anthracene compound is, for example, a 9-substituted carbonyloxyanthracene compound when having a -OC(O)OR group at position 9, and is a 9-alkoxycarbonyloxyanthracene compound when R is an alkyl group. The substituted anthracene compound is, for example, a 9,10-bis(substituted carbonyloxy)anthracene compound when having -OC(O)OR groups at positions 9 and 10, and is a 9,10-bis(alkoxycarbonyloxy)anthracene compound.

Examples of the alkyl group represented by R include a methyl group, an ethyl group, a n-propyl group, an i-propyl group, a n-butyl group, an i-butyl group, a pentyl group, a hexyl group, a heptyl group, an octyl group, a 2-ethylhexyl group, a nonyl group, a decyl group and a dodecyl group.

Examples of the allyl group represented by R include an allyl group and a methallyl group.

Examples of the aryl group represented by R include a phenyl group, a p-tolyl group, a m-tolyl group, an o-tolyl group, a 1-naphthyl group, and a 2-naphthyl group.

The substituted anthracene compound may further have one or two or more of any moiety selected from an alkyl group having 1 to 8 carbon atoms and halogen (a fluorine atom, a chlorine atom, a bromine atom, and an iodine atom), or both at a position other than positions 9 and 10.

Preferably, the 9-alkoxyanthracene compound is 9-ethoxyanthracene, and the 9,10-dialkoxyanthracene compound is one or more members selected from 9,10-diethoxyanthracene, 9,10-dipropoxyanthracene, 9,10-di(n-butoxy)anthracene, 9,10-di(s-butoxy)anthracene, 9,10-di(i-butoxy)anthracene and 9,10-di(t-butoxy)anthracene.

The 9,10-bis(substituted carbonyloxy)anthracene compound is preferably one or more members selected from 9,10-bis(methoxycarbonyloxy)anthracene, 9,10-bis(ethoxycarbonyloxy)anthracene, 9,10-bis(n-propoxycarbonyloxy)anthracene, 9,10-bis(i-propoxycarbonyloxy)anthracene, 9,10-bis(n-butoxycarbonyloxy)anthracene, 9,10-bis(i-butoxycarbonyloxy)anthracene, 9,10-bis(n-pentyloxycarbonyloxy)anthracene, 9,10-bis(n-hexyloxycarbonyloxy)anthracene, 9,10-bis(n-heptyloxycarbonyloxy)anthracene, 9,10-bis(n-octyloxycarbonyloxy)anthracene, 9,10-bis(2-ethylhexyloxycarbonyloxy)anthracene, 9,10-bis(n-nonyloxycarbonyloxy)anthracene, 9,10-bis(n-decyloxycarbonyloxy)anthracene, 9,10-bis(n-dodecyloxycarbonyloxy)anthracene and 9,10-bis(allyloxycarbonyloxy)anthracene.

It is more preferred to use a compound selected from: anthracene compounds such as 9,10-bis(methoxycarbonyloxy)anthracene, 9,10-bis(i-butoxycarbonyloxy)anthracene, 9,10-diphenylanthracene, 9,10-bis(phenylethynyl)anthracene, and 9,10-bis(n-octanoyloxy)anthracene; and carbazole compounds such as 4,4'-bis(9H-carbazol-9-yl)biphenyl and 9-phenylcarbazole; and benzoxazole compounds such as 2,5-thiophenediyl bis(5-tert-butyl-1,3-benzoxazole), from the viewpoint of the curability of a light blocking part.

It is more preferred to use a compound selected from: anthracene compounds such as 9,10-bis(n-octanoyloxy)anthracene; carbazole compounds such as 4,4'-bis(9H-carbazol-9-yl)biphenyl and 9-phenylcarbazole; stilbene compounds such as trans-1,2-diphenylethylene; and benzidine compounds such as N,N'-di(1-naphthyl)-N,N'-diphenylbenzidine, from the viewpoint of transparency. A carbazole compound is further preferred, and 4,4'-bis(9H-carbazol-9-yl)biphenyl or 9-phenylcarbazole is particularly preferred.

The component (C) may be used singly or in combinations of two or more thereof.

The amount of the component (C) is not particularly limited and can be appropriately adjusted. The amount is, for example, usually 0.01 parts by mass or more, preferably 0.1 parts by mass or more, more preferably 0.5 parts by mass or more and is usually 10 parts by mass or less, preferably 5 parts by mass or less, more preferably 3 parts by mass or less, per 100 parts by mass in total of the component (A) and the component (B).

<Component (D)>

The component (D) is a photopolymerization initiator. The component (D) is not particularly limited, and a photopolymerization initiator known in the art can be used.

Examples of the component (D) include: acetophenones such as acetophenone, 2,2-diethoxyacetophenone, m-chloroacetophenone, p-tert-butyltrichloroacetophenone, 4-dialkylacetophenone, and 2-benzylmethyl-2-dimethylamino-1-(4-morpholinophenyl)-butanone-1; benzophenones such as benzophenone; Michler's ketones such as Michler's ketone; benzyls such as benzyl and benzyl methyl ether; benzoins such as benzoin and 2-methylbenzoin; benzoin ethers such as benzoin methyl ether, benzoin ethyl ether, benzoin isopropyl ether, and benzoin butyl ether; benzyl dimethyl ketals such as benzyl dimethyl ketal; thioxanthones such as thioxanthone; various carbonyl compounds such as propiophenone, anthraquinone, acetoin, butyroin, toluoin, benzoyl benzoate, and $\alpha$-acyloxime ester; sulfur compounds such as tetramethyl thiuram disulfide, tetramethyl thiuram monosulfide, thioxanthone, 2-chlorothioxanthone, diphenyl disulfide, and 2-methyl-1-(4-methylthiophenyl)-2-morpholinopropan-1-one; azo compounds such as azobisisobutyronitrile and azobis-2,4-dimethylvaleronitrile; and peroxides such as benzoyl peroxide and di-tert-butyl peroxide. Other examples thereof include: phenyl glyoxylates; acylphosphine oxides such as 2,4,6-trimethylbenzoyl-diphenylphosphine oxide and bis(2,4,6-trimethylbenzoyl)-phenylphosphine oxide; organic dye compounds; and iron-phthalocyanine compounds.

In the sealant composition, the component (D) comprises two or more photopolymerization initiators differing in absorption wavelength. This changes a curing rate depending on an absorption wavelength and can allow a contact portion between an electrolyte and the sealant composition in an organic solar cell to be gelled early and then cured mainly.

Examples of the two or more photopolymerization initiators differing in absorption wavelength include a photopolymerization initiator having a high absorption coefficient having a main absorption wavelength of 300 nm or lower and a photopolymerization initiator having a high absorption coefficient having a main absorption wavelength exceeding 300 nm.

Examples of the photopolymerization initiator having a high absorption coefficient having a main absorption

wavelength of 300 nm or lower include: 2-hydroxy-2-methyl-1-phenylpropan-1-one (trade name "Darocur 1173" manufactured by BASF SE), 1-hydroxy cyclohexyl phenyl ketone (trade name "Irgacure 184" manufactured by BASF SE), 1-[4-(2-hydroxyethoxy)-phenyl]-2-hydroxy-2-methyl-1-propan-1-one (trade name "Irgacure 2959" manufactured by BASF SE), 2-hydroxy-1-{4-[4-(2-hydroxy-2-methylpropionyl)-benzyl]phenyl}-2-meth yl-1-one (trade name "Irgacure 127" manufactured by BASF SE), and 2-hydroxy-2-methyl-[4-(1-methylvinyl)phenyl]propanol oligomer (trade name "Esacure KIP-150" manufactured by Lamberti S.p.A.) as α-hydroxyalkylphenone-based radical polymerization initiators; and iodonium, 4-methylphenyl[4-(2-methylpropyl)phenyl]-, hexafluorophosphate (1-) (trade name "Irgacure 250" manufactured by BASF SE) and mixtures such as a blend of oxyphenylacetic acid, 2-[2-oxo-2-phenylacetoxyethoxy]ethyl ester and oxyphenylacetic acid, 2-(2-hydroxyethoxy)ethyl ester (Irgacure 754) as iodine salts. Irgacure 184, Esacure KIP-150, or the like is preferred from the viewpoint of transparency and curability.

Examples of the photopolymerization initiator having a high absorption coefficient having a main absorption wavelength exceeding 300 nm include 2-methyl-1-(4-methylthiophenyl)-2-morpholinopropan-1-one (trade name Irgacure 907), 2-benzylmethyl-2-dimethylamino-1-(4-morpholinophenyl)-butanone-1 (trade name Irgacure 369), 2,4,6-trimethylbenzoyl-diphenylphosphine oxide (trade name Lucirin TPO), and bis(2,4,6-trimethylbenzoyl)-phenylphosphine oxide (trade name Irgacure 819). Lucirin TPO, Irgacure 819, or the like is excellent from the viewpoint of the internal curability of an adhesive, etc.

The component (D) is used in combinations of two or more thereof.

The amount of the component (D) is not particularly limited and can be appropriately adjusted. The amount is, for example, usually 0.1 parts by mass or more, preferably 1 part by mass or more and is usually 10 parts by mass or less, preferably 5 parts by mass or less, per 100 parts by mass in total of the component (A) and the component (B). Also, the amount is usually 0.1 or more times and 10 or less times the weight of the component (C). The component (D)/component (C) molar ratio is usually 0.1 or more and 10.0 or less, preferably 0.5 or more and 8.0 or less, more preferably 3.5 or more and 6.0 or less.

(Other optional components)

The sealant composition may optionally comprise (E) a filler, a solvent, a catalyst, a colorant, a flame retardant, a plasticizer, an antioxidant, an antifoaming agent, a coupling agent, a leveling agent, a rheology controlling agent, a polymerization inhibitor, and the like for use in sealant compositions, in addition to the components (A), (B), (C) and (D) mentioned above. A polymerization inhibitor can be used for maintaining preservation stability. However, the polymerization inhibitor added in too large an amount improves preservation stability, but slows down reactivity. Therefore, the amount of the polymerization inhibitor is preferably 0.001 to 0.1 mass.

<Component (E)>

The component (E) is a filler and is an optional component. The component (E) is effective for enhancing a mechanical property and a moisture-proof property and effective for reducing gas transmittance. The component (E) is not particularly limited, and a filler selected from an inorganic filler and an organic filler known in the art can be used.

Examples of the inorganic filler include: oxide-based fillers such as silica, fine silicic acid powders, alumina, magnesium oxide, barium oxide, and calcium oxide; carbon black; graphite; hydroxide-based fillers such as aluminum hydroxide and magnesium hydroxide; sedimentary rock-based fillers such as diatomite and limestone; clay mineral-based fillers such as kaolinite and montmorillonite; magnetic fillers such as ferrite, iron, and cobalt; conductive fillers such as silver, gold, copper, alloys, and silica or resin particles surface-plated with these metals; and light calcium carbonate, heavy calcium carbonate, talc, and clay.

The type of the silica is not particularly limited and can be appropriately selected. Examples thereof include fumed silica and precipitated silica.

The type of the carbon black is not particularly limited and can be appropriately selected. Examples thereof include SRF, GPF, FEF, HAF, ISAF, SAF, FT, and MT.

Examples of the organic filler include silicone fillers, epoxy resin fillers, and polyamide fiber.

The component (E) may or may not be surface-treated, or may be a combination thereof. The component (E) is preferably surface-treated. The approach for surface treatment is not particularly limited, and an approach for surface treatment known in the art can be used. The component (E) may be surface-treated using, for example, a silane coupling agent; reactive silane such as hexamethyldisilazane, chlorosilane, or alkoxysilane; or low-molecular-weight siloxane.

Examples of the silane coupling agent can include 3-acryloyloxypropyltrimethoxysilane, 3-methacryloyloxypropyltrimethoxysilane, 3-acryloyloxypropyltriethoxysilane, 3-methacryloyloxypropyltriethoxysilane, 3-acryloyloxypropylmethyldimethoxysilane, 3-methacryloyloxypropylmethyldimethoxysilane, 3-acryloyloxypropylmethyldiethoxysilane, 3-methacryloyloxypropylmethyldiethoxysilane; 3-isocyanatopropyltriethoxysilane, 3-isocyanatopropyltrimethoxysilane, 3-isocyanatopropylmethyldiethoxysilane, 3-isocyanatopropylmethyldimethoxysilane; p-styryltrimethoxysilane, p-styryltriethoxysilane; vinyltrimethoxysilane, vinyltriethoxysilane, vinyltriisopropoxysilane, vinyltris(2-methoxyethoxy)silane; 2-(3,4-epoxycyclohexyl)ethyltrimethoxysilane, 3-glycidoxypropyltrimethoxysilane, 3-glycidoxypropylmethyldimethoxysilane, 3-glycidoxypropyltriethoxysilane, 3-glycidoxypropylmethyldiethoxysilane; N-2-(aminoethyl)-3-aminopropylmethyldimethoxysilane, N-(2-aminoethyl)-3-aminopropyltrimethoxysilane, N-(2-aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane; 3-mercaptopropyltrimethoxysilane, 3-mercaptopropyltriethoxysilane, and allyltrimethoxysilane.

The amount of the component (E) is not particularly limited and can be appropriately adjusted. The sealant composition comprises preferably 0.1 to 1000 parts by mass, more preferably 1 to 300 parts by mass, of the filler (E) per 100 parts by mass of the component (A). The shape is not particularly limited, and an amorphous shape such as particles, a spherical, plate-like, or rod-like shape, or the like can be appropriately selected. In the case of using the sealant composition of the disclosure, for example, in a dye-sensitized solar cell, the particle diameter can be appropriately selected according to the distance between a photoelectrode and a counter electrode and is usually 0.001 μm to 500 μm, preferably 0.01 to 50 μm.

<Method for preparing photocurable sealant composition>

The method for preparing the photocurable sealant composition is not particularly limited, and the photocurable sealant composition can be prepared by use of a method known in the art. The photocurable sealant composition can be prepared, for example, by mixing the components (A), (B), (C) and (D) mentioned above, and if necessary, other components using a mixing apparatus known in the art such as a sand mill, a disper blade, a collide mill, a planetary mixer, a kneader, or a triple roll mill.

<Method for curing photocurable sealant composition>

Active energy line such as ultraviolet ray, visible light, infrared ray, or electron beam is used as energy line for curing the photocurable sealant composition of the disclosure. Ultraviolet ray or electron beam is preferred for achieving high-speed printing.

Usually, an apparatus having a light source involving light in the range of 200 to 500 nm, for example, a high-pressure mercury lamp, an ultrahigh-pressure mercury lamp, a metal halide lamp, a gallium lamp, a xenon lamp, or a carbon arc lamp, can be used as an ultraviolet irradiation apparatus. On the other hand, in the case of curing the photocurable sealant composition with an electron beam, an electron beam acceleration apparatus having energy of 100 to 500 eV can usually be used.

The curing conditions, etc. can be practiced under conditions known in the art that are usually carried out. The integrated dose of active energy line is usually 100 to 10000 $mJ/cm^2$, preferably 200 to 5000 $mJ/cm^2$, more preferably 300 to 4000 $mJ/cm^2$.

The photocurable sealant composition of the disclosure may be used in every printing or coating such as flexographic printing, gravure printing, screen printing, inkjet printing, offset printing, bar coating, dip coating, flow coating, spray coating, spin coating, roller coating, reverse coating, air knives, and dispensing, which can be appropriately selected according to the shape of a substrate to be coated, etc.

The substrate to which the photocurable sealant composition is applied is preferably an organic resin.

The photocurable sealant composition according to the disclosure can be utilized in an article such as a solar cell, a display, an electronic component, a coating material, or an adhesive. Examples thereof include organic solar cells, microcomputers, transistors, capacitors, resistances, relays, transformers, and printed circuit boards with these components mounted thereon. Furthermore, the photocurable sealant composition may be utilized in: leads, harnesses, and film substrates to be joined to these electronic components; signal input units of flat-panel display panels such as liquid-crystal display panels, plasma display panels, organic electroluminescent panels, and field emission display panels; touch sensors of touch panels and wires thereof; etc.

(Article)

The article according to the disclosure is an article selected from the group consisting of a solar cell, a display, an electronic component, a coating material and an adhesive, comprising a cured product of any of the photocurable sealant compositions described above. The article comprising such a cured product has high reliability.

The article according to the disclosure can comprise a cured product of the photocurable sealant composition, and a sealant obtained by photocuring the photocurable sealant composition can be used instead of a conventional sealant.

(Organic solar cell)

The organic solar cell is an organic solar cell comprising:

a first electrode substrate;
a second electrode substrate;
a light blocking member; and
a sealant, wherein
the first electrode substrate and the second electrode substrate are disposed to face each other,
the first electrode substrate has two surfaces, a first surface and a second surface,
the first surface of the first electrode substrate faces the second electrode substrate,
the second surface of the first electrode substrate is a light incident surface,
the light blocking member is disposed on the first surface of the first electrode substrate, and
the sealant is positioned at least at a light blocking part on a side opposite to the light incident surface side, of the light blocking member. The organic solar cell comprising such a cured product has high reliability.

Examples of the organic solar cell include organic solar cells such as dye-sensitized solar cells and perovskite solar cells.

Hereinafter, a dye-sensitized solar cell will be described as one example of the organic solar cell according to the disclosure.

FIG. 1 shows one example of a structure of the organic solar cell (series dye-sensitized solar cell). This organic solar cell 1 comprises first electrode substrate (photoelectrode substrate) 11, second electrode substrate (counter electrode substrate) 12, light blocking member 15, and sealant 16. The first electrode substrate 11 and the second electrode substrate 12 are disposed to face each other. The first electrode substrate 11 has two surfaces, first surface 17 and second surface 18. The first surface 17 of the first electrode substrate 11 faces the second electrode substrate 12. The second surface 18 of the first electrode substrate 11 is a light incident surface. The light blocking member 15 is disposed on the first surface 17 of the first electrode substrate 11. At least a part on a side opposite to the light incident surface side, of the light blocking member 15 is light blocking part 19. The sealant 16 is positioned at the light blocking part 19. In this example shown in FIG. 1, the light blocking member 15 is silver wire 20 and conductive connection material 21. Electrolyte layer (electrolyte solution) 22 is encapsulated in a space surrounded by the first electrode substrate 11, the second electrode substrate 12, and the sealant 16. Porous semiconductor fine particle layer 23 and catalyst layer 24 are disposed between the silver wires 20.

The organic solar cell can also be suitably used when the first electrode substrate filters out 50% or more of a wavelength of 300 nm or lower.

For the organic solar cell, it is preferred that the sealant should be a cured product of a photocurable sealant composition comprising an aromatic sensitization aid capable of absorbing light having a wavelength of 300 nm or higher. This enhances the reliability of the sealant at the light blocking part. Examples of such an aromatic sensitization aid include the component (C) of the photocurable sealant composition described above.

<Sealant>

The sealant includes (1) a radical photocuring system, (2) a photo cationic curing system, and (3) a anionic photocuring system and is preferably a radical photocuring system.

Examples of the resin of the radical photocuring system (1) can include epoxy acrylate, polyester acrylate, urethane acrylate, polybutadiene acrylate, polyisoprene acrylate, polyisobutylene acrylate, polyol acrylate, polyether acrylate, and silicone resin acrylate. Among them, epoxy acrylate, urethane acrylate, or polyester acrylate is preferred.

The epoxy acrylate is a compound having one or more (meth)acrylic acids introduced in one epoxy resin molecule containing [-CH(OH)-$CH_2$O-] derived from an epoxy group. A functional group other than an epoxy residue, for example, an ether group or a hydroxy group, may be contained therein. Examples of such polyfunctional epoxy acrylate include bisphenol A-type epoxy acrylate, bisphenol F-type epoxy acrylate, biphenyl-type epoxy acrylate, phenol novolac-type epoxy acrylate, cresol novolac-type epoxy acrylate, epoxy acrylate of an aliphatic polyhydric alcohol, and alicyclic epoxy acrylate. The epoxy acrylate may be used singly or as a mixture of two or more thereof.

The polyester acrylate is a derivative in which (meth)acrylic acid is ester-bonded to one or more alcohol residues of a polyester obtained by the dehydration and condensation of a polybasic acid and a polyhydric alcohol. A functional group other than an ester group, for example, an ether group or a hydroxy group, may be contained in the molecule. Examples of the dibasic acid include maleic acid, fumaric acid, adipic acid, phthalic acid, isophthalic acid, and tetrachlorophthalic acid. Examples of the polyhydric alcohol include ethylene glycol, diethylene glycol, propylene glycol, neopentyl glycol, glycerin glycol, and trimethylolpropane. The polyester acrylate may be used singly or as a mixture of two or more thereof.

The urethane acrylate is obtained by reacting polyisocyanate, polyol and hydroxy group-containing (meth)acrylate by a heretofore known method. Specifically, a polymer polyisocyanate is first formed by reacting polyisocyanate with polyol and subsequently reacted with hydroxy group-containing (meth)acrylate to bond an unsaturated group to the end. Alternatively, hydroxy group-containing (meth)acrylate is first reacted with polyisocyanate, and the obtained unsaturated polyisocyanate is subsequently reacted with polyol, if necessary in the presence of polyisocyanate.

Examples of the polyol for urethane acrylate include polyethylene glycol, polypropylene glycol, polytetramethylene ether glycol and copolymers thereof, ethylene glycol, propylene glycol, 1,4-butanediol, and 2,2'-thiodiethanol. These polyols may be used singly or as a mixture of two or more thereof. Examples of the hydroxy group-containing (meth)acrylate for urethane acrylate include 2-hydroxyethyl (meth)acrylate, 2-hydroxypropyl (meth)acrylate, pentaerythritol tri(meth)acrylate, 1,4-butanediol mono(meth)acrylate, and caprolactone-modified 2-hydroxyethyl (meth)acrylate. The resin of the radical photocuring system may further contain <component B> mentioned above. The resin may contain 1 to 300 parts by mass of the component (B) per 100 parts by mass of the resin of the radical photocuring system.

Examples of the resin of the photo cationic curing system (2) include vinyl ether compounds, oxetane compounds, and epoxy compounds. Examples of the vinyl ether compound include methyl vinyl ether, ethyl vinyl ether, and isopropyl vinyl ether. Examples of the oxetane compound include 2-ethylhexyloxetane, 3-ethyl-3-hydroxymethyloxetane (oxetane alcohol), allyloxyoxetane, xylylenebisoxetane, and 3-ethyl-3{[(3-ethyloxetan-3-yl)methoxy]methyl}oxetane. Examples of the epoxy compound include alicyclic epoxy compounds, aromatic glycidyl ether compounds, epoxy-modified silicone compounds, and isocyanuric compounds. Specific examples of the alicyclic epoxy compound include 3,4-epoxycyclohexylmethyl-3,4-epoxycyclohexanecarboxylate and bis(3,4-epoxycyclohexyl)adipate. For example, UVR6110 and UVR6105 manufactured by The Dow Chemical Company are commercially available. Specific examples of the aromatic glycidyl ether compound include 2,2'-bis(4-glycidyloxyphenyl)propane. Specific examples of the isocyanuric compound include TEPIC-PAS (containing 3 epoxy groups) manufactured by Nissan Chemical Corp., a 1-modification of TEPIC-PAS (containing 2 epoxy groups), a 2-modification of TEPIC-PAS (containing 1 epoxy group), TEIPC-UC, TEPIC-VL, and TEPIC-FL.

Examples of the resin of the photo anionic curing system (3) include vinyl ether compounds, oxetane compounds, and epoxy compounds. Examples of the vinyl ether compound include methyl vinyl ether, ethyl vinyl ether, and isopropyl vinyl ether. Examples of the oxetane compound include 2-ethylhexyloxetane, 3-ethyl-3-hydroxymethyloxetane (oxetane alcohol), allyloxyoxetane, xylylenebisoxetane, and 3-ethyl-3{[(3-ethyloxetan-3-yl)methoxy]methyl}oxetane. Examples of the epoxy compound include alicyclic epoxy compounds, hydrogenated epoxy compounds, aromatic glycidyl ether compounds, epoxylated polybutadiene, epoxy-modified silicone compounds, and isocyanuric compounds. Specific examples of the alicyclic epoxy compound include 3,4-epoxycyclohexylmethyl-3,4-epoxycyclohexanecarboxylate and bis(3,4-epoxycyclohexyl)adipate. For example, UVR6110 and UVR6105 manufactured by The Dow Chemical Company are commercially available. Specific examples of the hydrogenated epoxy compound include hydrogenated novolac-type epoxy compounds and hydrogenated bisphenol compounds. For example, YX8034 (bisphenol A-type epoxy resin) manufactured by Japan Epoxy Resin Co., Ltd. UXA7015 manufactured by DIC Corp., ST3000 manufactured by Tohto Kasei Co., Ltd., Rikaresin HBE-100 manufactured by Nippon Rika Industries Corp., and ST-3000 and ST4000D manufactured by Nippon Steel & Sumikin Chemical Co., Ltd. are commercially available. Specific examples of the aromatic glycidyl ether compound include 2,2'-bis(4-glycidyloxyphenyl)propane. Specific examples of the isocyanuric compound include TEPIC-PAS (containing 3 epoxy groups) manufactured by Nissan Chemical Corp., a 1-modification of TEPIC-PAS (containing 2 epoxy groups), a 2-modification of TEPIC-PAS (containing 1 epoxy group), TEIPC-UC, TEPIC-VL, and TEPIC-FL. Among them, an alicyclic epoxy compound, a hydrogenated epoxy compound, or the like is preferred from the viewpoint of resistance to an electrolyte solution.

The resin may be used singly or in combinations of two or more thereof. A combination of a resin of the radical photocuring system and a resin of the photo cationic curing system, a combination of a resin of the radical photocuring system and a resin of the photo anionic curing system, or the like is preferred because of achieving both a curing rate and close adherence.

A compound that generates a radical, an acid, a base, or the like by irradiation with active energy line such as visible light or ultraviolet ray may be used as a curing agent. For example, the component D described in the photocurable sealant composition described above can be used as the compound that generates a radical by light irradiation. An aromatic iodonium salt or an aromatic sulfonium salt, which is an onium salt, can be used as the compound that generates an acid by light irradiation. Examples of the aromatic iodonium salt include 4-isobutylphenyl-4'-methylphenyliodonium hexafluorophosphate, bis(dodecylphenyl)iodonium hexafluoroantimonate, and 4-isopropylphenyl-4'-methylphenyliodonium tetrakispentafluorophenylborate. For example, Irgacure 250 manufactured by Ciba Specialty Chemicals (mixture of 4-isobutylphenyl-4'-methylphenyliodonium hexafluorophosphate and a solvent; Irgacure is a registered trademark of Ciba Specialty Chemicals) or 2074 manufactured by Rhodia Japan, Ltd. (4-isopropylphenyl-4'-methylphenyliodonium tetrakispentafluorophenylborate) can be used. Examples of the aromatic sulfonium salt include S,S,S',S'-tetraphenyl-S,S'-(4, 4'-thiodiphenyl)disulfonium bishexafluorophosphate, diphenyl-4-phenylthiophenylsulfonium hexafluorophosphate, and triphenylsulfonium hexafluorophosphate. For example, UVI6992 (S,S,S',S'-tetraphenyl-S,S'-(4, 4'-thiodiphenyl)disulfonium bishexafluorophosphate) manufactured by The Dow Chemical Company can be used. Examples of a

commercially available product include WPI series such as product names WPI-113, 116, 1169, 170, and 124 manufactured by Wako Pure Chemical Industries, Ltd.

Examples of the base that is generated by the light irradiation of the curing agent include amine compounds, imidazole compounds, amidine compounds, guanidine compounds, phosphine compounds, and boron compounds.

The curing agent can be any compound capable of generating a base by light irradiation and is not particularly limited. A photobase generator known in the art can be used. Examples of the curing agent can include: imidazole derivatives such as N-(2-nitrobenzyloxycarbonyl)imidazole, N-(3-nitrobenzyloxycarbonyl)imidazole, N-(4-nitrobenzyloxycarbonyl)imidazole, N-(4-chloro-2-nitrobenzyloxycarbonyl)imidazole, N-(5-methyl-2-nitrobenzyloxycarbonyl)imidazole, and N-(4,5-dimethyl-2-nitrobenzyloxycarbonyl)imidazole; and N-(2-methyl-2-phenylpropionyloxy)-N-cyclohexylamine.

Specific examples of the curing agent can include: nonionic photobase generators such as 9-anthrylmethyl N,N-diethylcarbamate, (E)-1-[3-(2-hydroxyphenyl)-2-propenoyl]piperidine, 1-(anthraquinon-2-yl)ethyl imidazole carboxylate, and 2-nitrophenylmethyl 4-methacryloyloxypiperidine-1-carboxylate; and ionic photobase generators such as 1,2-diisopropyl-3-[bis(dimethylamino)methylene]guanidium 2-(3-benzoylphenyl)propionate and 1,2-dicyclohexyl-4,4,5,5-tetramethylbiguanidium n-butyltriphenylborate. These curing agents can be appropriately selected and may be used in combination with a sensitizer.

The method for preparing the curing agent is not particularly limited, and a method known in the art can be used. Examples thereof include a synthesis method of reacting a nitrobenzyl alcohol derivative as a starting material with carbonyldiimidazole. Also, the curing agent can be prepared in accordance with, for example, a method described in Nishikubo, T. et al, Polym. J., 26 (7), 864 (1994).

A commercially available product may be used as the curing agent. Examples of the commercially available product include WPBG series such as product names WPBG-018, 027, 140, 165, 266, and 300 manufactured by Wako Pure Chemical Industries, Ltd.

The amount of the curing agent contained is not particularly limited and can be appropriately adjusted. The amount is, for example, usually 0.01 parts by mass or more, preferably 0.1 parts by mass or more, more preferably 1 part by mass or more and is usually 20 parts by mass or less, preferably 10 parts by mass or less, more preferably 5 parts by mass or less, particularly preferably 3 parts by mass or less, per 100 parts by mass in total of the resins.

The curing agent may be used singly or in combinations of two or more thereof.

In addition to those described above, various materials described in the photocurable sealant composition described above may be used.

Hereinafter, examples of a photoelectrode, an electrolyte layer, and a counter electrode in a dye-sensitized solar cell as one example of the organic solar cell will be described.

<Photoelectrode>

The photoelectrode is not particularly limited, and a photoelectrode known in the art can be appropriately selected and used. For example, the photoelectrode may consist of a photoelectrode substrate (first electrode substrate), a porous semiconductor fine particle layer formed thereon, and a sensitizing dye layer formed by adsorbing a sensitizing dye onto the surface of this porous semiconductor fine particle layer. A photoelectrode substrate with a current collecting wire such as a silver wire formed thereon plays a role in supporting the porous semiconductor fine particle layer and the like, and a role as a current collector.

The photoelectrode substrate is not particularly limited, and a photoelectrode substrate known in the art can be appropriately selected and used. Examples thereof include conductive films having a substrate such as a transparent resin or glass coated with a metal (Au, Ag, Cu, etc.) mesh conductive film or metal (Ag, Ag wire, etc.) nanoparticles, conductive films made of composite metal oxide such as indium tin oxide (ITO), indium zinc oxide (IZO), or fluorine-doped tin (FTO), carbon-based conductive films such as carbon nanotubes and graphene, conductive polymer films such as PEDOT/PSS, and products prepared by stacking layers containing a mixture or a stack thereof, and in the case of requiring no permeability, foils and plates of titanium, SUS, aluminum, or the like. The surface resistance value of the conductive film is preferably 100 $\Omega$/sq or less, more preferably 50 $\Omega$/sq or less, further preferably 30 $\Omega$/sq or less, still further preferably 10 $\Omega$/sq or less, most preferably 5 $\Omega$/sq or less. The light transmittance (measurement wavelength: 500 nm) of the photoelectrode substrate having a transparent electrode layer provided on a transparent substrate is preferably 60% or more, more preferably 75% or more, most preferably 80% or more.

Examples of the transparent resin include synthetic resins such as polyethylene terephthalate (PET), polyethylene naphthalate (PEN), syndiotactic polystyrene (SPS), polyphenylene sulfide (PPS), polycarbonate (PC), polyarylate (PAr), polysulfone (PSF), polyester sulfone (PES), polyetherimide (PEI), transparent polyimide (PI), and cycloolefin polymer (COP).

The substrate for the photoelectrode substrate is preferably an organic resin.

The dye-sensitized solar cell preferably has a substrate and/or an electrode substrate that filters out 50% or

more of a wavelength of 300 nm or lower, on a surface to be irradiated with photoenergy. Examples of such a substrate include UV-cut films stacked on substrates, for example, attached to glass substrates or organic substrates (polyethylene terephthalate (PET), cycloolefin polymer, and polyethylene naphthalate (PEN), etc.), such as E-Star and E-Star UV-Cut manufactured by Mitsubishi Plastics, Inc., and Scotchtint manufactured by 3M Company. Other examples thereof include glass, polyethylene naphthalate, polyethylene terephthalate (PET), polyethylene naphthalate (PEN), syndiotactic polystyrene (SPS), polyphenylene sulfide (PPS), polycarbonate (PC), polyarylate (PAr), polysulfone (PSF), polyester sulfone (PES), polyetherimide (PEI), and transparent polyimide (PI) with an ITO, FTO, carbon (graphene, carbon nanotubes, etc.), conductive polymer (PEDOT, etc.), or noble metal (platinum, etc.) conductive layer stacked thereon, and electrode substrates such as polyethylene terephthalate, polyetherimide (PEI), and transparent polyimide (PI).

The porous semiconductor fine particle layer is a porous layer containing semiconductor fine particles. The porous layer increases the amount of the sensitizing dye adsorbed and facilitates obtaining a dye-sensitized solar cell having high conversion efficiency.

Examples of the semiconductor fine particles include particles of metal oxides such as titanium oxide, zinc oxide, and tin oxide.

The particle diameter (average particle diameter of primary particles) of the semiconductor fine particles is not particularly limited and can be appropriately adjusted. The particle diameter is preferably 2 to 80 nm, more preferably 2 to 60 nm. A small particle diameter can reduce resistance.

The thickness of the porous semiconductor fine particle layer is not particularly limited and is usually 0.1 to 50 μm, preferably 5 to 30 μm.

The method for forming the porous semiconductor fine particle layer is not particularly limited, and a method known in the art can be appropriately selected and used. The porous semiconductor fine particle layer can be formed by a method known in the art, for example, a press process, a hydrothermal decomposition process, an electrophoretic deposition process, or a binder-free coating process.

The sensitizing dye layer is a layer prepared by adsorbing a compound capable of transferring electrons to the porous semiconductor fine particle layer by excitation with light (sensitizing dye) onto the surface of the porous semiconductor fine particle layer.

The sensitizing dye is not particularly limited, and a sensitizing dye for dye-sensitized solar cells known in the art can be appropriately selected and used. Examples thereof include: organic dyes such as cyanine dyes, merocyanine dyes, oxonol dyes, xanthene dyes, squarylium dyes, polymethine dyes, coumarin dyes, riboflavin dyes, and perylene dyes; and metal complex dyes such as phthalocyanine complexes and porphyrin complexes of metals such as iron, copper, and ruthenium. Typical examples of the sensitizing dye include N3, N719, N749, D102, D131, D150, N205, HRS-1, and MK-2. It is preferred that an organic solvent that dissolves the dye should be degassed and distilled and purified in advance in order to remove water and gases present in the solvent. The solvent is preferably a solvent including: alcohols such as methanol, ethanol, and propanol; nitriles such as acetonitrile; and halogenated hydrocarbons, ethers, amides, esters, carbonic acid esters, ketones, hydrocarbons, aromatic solvents, and nitromethane.

The method for forming the sensitizing dye layer is not particularly limited, and a method known in the art can be appropriately selected and used. The sensitizing dye layer can be formed by a method, for example, a method of dipping the porous semiconductor fine particle layer in a solution of the sensitizing dye, or a method of coating the porous semiconductor fine particle layer with a solution of the sensitizing dye.

<Electrolyte layer>

The electrolyte layer is a layer for separating the photoelectrode from a counter electrode while efficiently performing charge transfer. The electrolyte layer is not particularly limited by a solid, a liquid, or a semisolid such as a gel. The electrolyte layer usually contains a supporting electrolyte, a redox couple (a pair of chemical species capable of being mutually reversibly converted in the forms of an oxidant and a reductant in redox reaction), a solvent, and the like.

Examples of the supporting electrolyte include ionic liquids containing salts of alkali metals (lithium ions, etc.), alkaline earth metals, or the like, imidazolium ions, compounds having a quaternary nitrogen atom as a spiro atom, cations such as quaternary ammonium ions.

A redox couple known in the art can be used as long as the redox couple is capable of reducing an oxidized sensitizing dye. Examples of the redox couple include chlorine compound-chlorine, iodine compound-iodine, bromine compound-bromine, thallium ion(III)-thallium ion(I), ruthenium ion(III)-ruthenium ion(II), copper ion(II)-copper ion(I), iron ion(III)-iron ion(II), cobalt ion(III)-cobalt ion(II), vanadium ion(III)-vanadium ion(II), manganate ion-permanganate ion, ferricyanide-ferrocyanide, quinone-hydroquinone, and fumaric acid-succinic acid.

A solvent known in the art for the formation of electrolyte layers for solar cells can be used as the solvent. Examples of the solvent include acetonitrile, methoxyacetonitrile, methoxypropionitrile, N,N-dimethylformamide, ethyl methylimidazolium bistrifluoromethylsulfonylimide, propylene carbonate, glycol ether, and γ-butyrolactone.

The method for forming the electrolyte layer is not particularly limited, and a method known in the art can be

appropriately selected and used. The electrolyte layer can be formed, for example, by coating a photoelectrode with a solution containing a component constituting the electrolyte layer (electrolyte solution); or preparing a cell having a photoelectrode and a counter electrode and injecting an electrolyte solution to a gap therebetween.

<Light blocking member>

The light blocking member is a member that blocks light or reduces permeability by 50% or more. Specifically, the light blocking member includes a current collecting wire on electrode surface mentioned later, a conductive connection material for use in connecting electrodes, a catalyst layer made of a carbon material or a carbon nanocomposite on a counter electrode mentioned later, an extraction electrode, and the like.

<Light blocking part>

The light blocking part is a part on a side opposite to the light incident surface side, of the light blocking member and is a part for which light is blocked or permeability is reduced by 50% or more by the light blocking member. The sealant is positioned at this light blocking part.

<Conductive connection material>

The conductive connection material establishes the conductive connection between the photoelectrode and the counter electrode in a cell. The conductive connection material is used for the series connection and/or parallel connection of a certain cell of the solar cell with an adjacent cell. For example, for a Z-type solar cell, the conductive connection material establishes the conduction between the photoelectrode and the counter electrode up and down in the vertical cross-sectional view as shown in FIG. 1, and connects cells. The conductive connection material is not particularly limited as long as the conductive connection material has conductivity. For example, a metal (gold, silver, copper, titanium, carbon, etc.) filler, glass beads, polystyrene or acrylic resin particles surface-plated with gold, silver, copper, nickel, or the like, or an anisotropically conductive film is usually used. Plated particles are preferred because the particle diameter can be uniformly controlled. The particle diameter can be appropriately selected and is usually 0.1 to 100 $\mu$m, preferably 1 to 30 $\mu$m, more preferably 3 to 15 $\mu$m. The amount of these materials contained is usually 0.01 to 20% by volume, preferably 0.05 to 10% by volume, more preferably 0.1 to 5% by volume, in the whole sealant composition.

<Current collecting wire>

It is preferred to perform design such that a transparent conductive film of the photoelectrode or the counter electrode is equipped with a current collecting wire so that cell compartments are established to rapidly perform current transfer within the electrode. The current collecting wire for the photoelectrode and the counter electrode is preferably made of at least one or more metals selected from silver, copper, aluminum, tungsten, nickel, and chromium, or an alloy thereof. The current collecting wire also preferably has a grid-like shape formed on the transparent substrate. For example, sputtering, deposition, plating or screen printing is used as a method for forming the current collecting wire.

<Counter electrode>

A counter electrode known in the art can be appropriately selected and used as the counter electrode. Examples thereof include counter electrodes having a conductive film and a catalyst layer in this order on a substrate (second substrate).
The substrate plays a role in supporting the catalyst layer. Examples of the substrate include: conductive sheets formed using metals, metal oxides, carbon materials, conductive polymers, or the like; and nonconductive sheets made of a transparent resin or glass.
Examples of the transparent resin include the transparent resins listed in the photoelectrode described above.
Examples of the conductive film include the conductive films listed in the photoelectrode described above as well as conductive films made of carbon materials such as carbon nanobuds and fullerene, and combinations of two or more thereof.
The catalyst layer functions as a catalyst when electrons are transferred from the counter electrode to the electrolyte layer in the dye-sensitized solar cell. A catalyst layer known in the art can be appropriately selected and used as the catalyst layer. The catalyst layer preferably contains, for example, a conductive polymer, a carbon nanostructure, and noble metal particles having a catalytic effect, or both a carbon nanostructure and noble metal particles.
Examples of the conductive polymer can include: polythiophenes such as poly(thiophene-2,5-diyl), poly(3-butylthiophene-2,5-diyl), poly(3-hexylthiophene-2,5-diyl), and poly(2,3-dihydrothieno-[3,4-b]-1,4-dioxin) (PEDOT); polyacetylene and its derivatives; polyaniline and its derivatives; polypyrrole and its derivatives; and polyphenylenevinylenes such as poly(p-xylene tetrahydrothiophenium chloride), poly[(2-methoxy-5-(2'-ethylhexyloxy))-1,4-phenylenevinylene], poly[(2-methoxy-5-(3',7'-dimethyloctyloxy)-1,4-phenylenevinylene)], and poly[2-2',5'-bis(2"-ethylhexyloxy)phenyl]-1,4-phenylenevinylene].

Examples of the carbon nanostructure can include natural graphite, activated carbon, artificial graphite, graphene, carbon nanotubes, and carbon nanobuds.

The noble metal particles are not particularly limited as long as the noble metal particles have a catalytic effect. Noble metal particles known in the art can be appropriately selected and used. Examples thereof include metal platinum, metal palladium and metal ruthenium.

The method for forming the catalyst layer is not particularly limited, and a method known in the art can be appropriately selected and used. The method can be performed, for example, by dissolving or dispersing the conductive polymer, the carbon nanostructure, or the noble metal particles, or both the carbon nanostructure and the noble metal particles in an appropriate solvent, applying or spraying the obtained mixed solution onto a conductive film, and drying the solvent in the mixed solution. In the case of using the carbon nanostructure and/or the noble metal particles, the mixed solution may further contain a binder. A polymer having, for example, a functional group such as a hydroxy group, a carboxyl group, a sulfonyl group, or a phosphate group, or a sodium salt of the functional group is preferably used as the binder from the viewpoint of the dispersibility of the carbon nanostructure and close adherence to the substrate.

The catalyst layer may contain a carbon nanotube whose average diameter (Av) and standard deviation ($\sigma$) of diameter satisfy $0.60 > 3\sigma/Av > 0.20$ (hereinafter, also referred to as the expression (A)) (hereinafter, also referred to as a "specific carbon nanotube"). In this context, the "specific carbon nanotube" is a collective term for a population of predetermined carbon nanotubes constituting it, and the "diameter" means the outside diameters of the predetermined carbon nanotubes.

The average diameter (Av) and standard deviation ($\sigma$) of diameter of the specific carbon nanotube are a sample average value and a sample standard deviation, respectively. They are determined as an average value and a standard deviation of the diameters of 100 randomly selected carbon nanotubes measured by observation under a transmission electron microscope. $3\sigma$ in the expression (A) is determined by multiplying the obtained standard deviation ($\sigma$) by 3.

A counter electrode having excellent catalytic activity can be obtained by using the specific carbon nanotube. $0.60 > 3\sigma/Av > 0.25$ is preferred, and $0.60 > 3\sigma/Av > 0.50$ is more preferred, from the viewpoint of improving the characteristics of the resulting counter electrode.

$3\sigma/Av$ represents the diameter distribution of the specific carbon nanotube. A larger value of this $3\sigma/Av$ means a wider diameter distribution. The diameter distribution preferably assumes a normal distribution. In this case, the diameter distribution can be observed under a transmission electron microscope and is obtained by measuring the diameters of 100 randomly selected carbon nanotubes, and plotting the obtained data with diameter on the abscissa against frequency on the ordinate using the results, followed by Gaussian approximation. The value of $3\sigma/Av$ may be increased by combining a plurality of carbon nanotubes, etc. obtained by different production methods. In this case, however, it is difficult to obtain a normal distribution as the diameter distribution. The specific carbon nanotube may consist of one type of carbon nanotube or may be one type of carbon nanotube supplemented with different carbon nanotubes in an amount that does not influence the diameter distribution.

The average diameter (Av) of the specific carbon nanotube is preferably 0.5 nm or larger and 15 nm or smaller, more preferably 1 nm or larger and 10 nm or smaller, from the viewpoint of obtaining excellent catalytic activity.

The average length of the specific carbon nanotube is preferably 0.1 $\mu$m to 1 cm, more preferably 0.1 $\mu$m to 1 mm. When the average length of the specific carbon nanotube falls within the range described above, a highly active catalyst layer is easily formed. The average length of the specific carbon nanotube can be calculated, for example, by measuring 100 randomly selected carbon nanotubes under a transmission electron microscope.

The specific surface area of the specific carbon nanotube is preferably 100 to 2500 $m^2/g$, more preferably 400 to 1600 $m^2/g$. When the specific surface area of the specific carbon nanotube falls within the range described above, a highly active catalyst layer is easily formed. The specific surface area of the specific carbon nanotube can be determined by a nitrogen gas adsorption method.

The carbon nanotubes constituting the specific carbon nanotube may have a single wall or may have multiple walls. Single-walled to 5-walled carbon nanotubes are preferred from the viewpoint of improving the activity of the catalyst layer.

The carbon nanotubes constituting the specific carbon nanotube may contain a functional group such as carboxyl group introduced to the surface. The introduction of the functional group can be performed by an oxidation treatment method known in the art using hydrogen peroxide, nitric acid, or the like.

The specific carbon nanotube can be obtained by a method known in the art, for example, a method of supplying a starting compound and a carrier gas onto a substrate having a catalyst layer for carbon nanotube production (hereinafter, also referred to as a "catalyst layer for CNT production") on the surface (hereinafter, also referred to as a "substrate for

CNT production"), and synthesizing carbon nanotubes by chemical vapor deposition (CVD) in the presence of a trace amount of an oxidizing agent in the system to thereby drastically improve the catalytic activity of the catalyst layer for CNT production (super growth method) (e.g., International Publication No. WO 2006/011655). Hereinafter, the carbon nanotube produced by the super growth method is also referred to as SGCNT.

The catalyst layer constituted by the specific carbon nanotube as a material has sufficient activity even if containing no metal. Thus, the catalyst layer may not contain a metal. However, the specific carbon nanotube may support a trace amount of nanosized platinum or the like. In this case, improvement in catalytic effect is improved. The supporting of the metal by the carbon nanotubes can be performed according to a method known in the art.

The thickness of the catalyst layer is preferably 0.005 $\mu$m to 100 $\mu$m.

The amount of the specific carbon nanotube contained in the catalyst layer is preferably 0.1 to $2 \times 10^4$ mg/m$^2$, more preferably 0.5 to $5 \times 10^3$ mg/m$^2$.

The counter electrode comprising the catalyst layer constituted by the specific carbon nanotube as a material can be prepared, for example, by preparing a dispersion liquid containing the specific carbon nanotube, coating a substrate with this dispersion liquid, and drying the obtained coating film to form the catalyst layer.

Examples of the solvent for use in the preparation of the dispersion liquid include: water; alcohols such as methanol, ethanol, and propanol; ketones such as acetone and methyl ethyl ketone; ethers such as tetrahydrofuran, dioxane, and diglyme; amides such as N,N-dimethylformamide, N,N-dimethylacetamide, N-methyl-2-pyrrolidone, and 1,3-dimethyl-2-imidazolidinone; and sulfur-containing solvents such as dimethyl sulfoxide and sulfolane. These solvents can be used singly or in combinations of two or more thereof.

The dispersion liquid may contain a dispersant for improving the dispersibility of the specific carbon nanotube. Preferred examples of the dispersant include: ionic surfactants known in the art; nonionic surfactants such as carboxyl methyl cellulose (CMC) and carboxyl methyl cellulose salt; and polymer activators such as polystyrenesulfonates such as sodium polystyrenesulfonate.

The dispersion liquid may further contain a binder, a conductive additive, a surfactant, and the like. Those known in the art can be appropriately used thereas.

The dispersion liquid can be obtained, for example, by mixing the specific carbon nanotube and if necessary, other components in a solvent to disperse the carbon nanotubes.

The mixing treatment or the dispersion treatment can employ a method known in the art. Examples thereof include methods using a nanomizer, an ultimizer, an ultrasonic disperser, a ball mill, a sand grinder, a dyno-mill, a spike mill, DCP MILL, a basket mill, a paint conditioner, or a high-speed stirring apparatus.

The content of the specific carbon nanotube in the dispersion liquid is not particularly limited and is preferably 0.001 to 10% by mass, more preferably 0.01 to 5% by mass, in the whole dispersion liquid.

<Others>

One or both of the photoelectrode and the counter electrode acting as electrodes may be provided with a functional layer such as an antifouling layer, a protective layer (hard coat, etc.), an antireflection layer, or a gas barrier layer. A thin film layer of a compact semiconductor (metal oxide $TiO_2$, $SnO_2$, $Fe_2O_3$, $WO_3$, ZnO, $Nb_2O_5$, etc.) may be provided as a foundation layer between the first electrode substrate and the porous semiconductor layer. Also, a separator for the prevention of short circuits may be contained therein.

FIG. 2 shows another example of the structure of the organic solar cell according to the disclosure. As shown in FIG. 2, the organic solar cell may have a double seal structure having second sealant 25 outside of first sealant 16 which comes into contact with electrolyte solution 22.

<Extraction electrode>

An extraction electrode can be established in order to extract current from the prepared module. Usually, the position, material, preparation method, etc. of the extraction electrode are not particularly limited and can be practiced by a method known in the art. Paste of a metal (aluminum, nickel, stainless steel, copper, gold, silver, solder, etc.) or carbon, conductive tape, or the like can be used as the material. The extraction electrode can be appropriately prepared on one of the photoelectrode and counter electrode sides and/or on each negative electrode or positive electrode side.

The structure of the module is not particularly limited and includes Z type, W type, parallel type, current collecting sequence type, monolithic type, etc. One or two or more in combination of these modules may be connected in series or in parallel, and a plurality of such modules may be connected. Means known in the art can be used as a connection method, and solder, a metal plate, a cable, a flat cable, a flexible substrate, a cable, or the like can be appropriately selected.

In addition to the dye-sensitized solar cell mentioned above, examples of the perovskite solar cell include perovskite solar cells described in JP2014-049631A, JP2015-046583A, and JP2016-009737A.

<Method for producing solar cell module>

The method for producing the module is not particularly limited, and the module can be produced by a method known in the art such as one drop filling (ODF) or end sealing. Examples of the ODF include methods described in WO2007/046499. Examples of the end sealing include methods described in JP2006-004827A. These modules may be stacked or packaged and outer-packaged with a gas barrier film or the like. Examples of the gas barrier film include films in which a barrier layer made of silicon oxide, aluminum oxide, aluminum, or the like having low water vapor or gas permeability is stacked on a plastic support by a method known in the art.

EXAMPLES

Hereinafter, the disclosure will be described in more detail with reference to Examples. However, these Examples are intended to illustrate the disclosure and do not limit the disclosure by any means. The amount contained means parts by mass unless otherwise specified.
The detailed materials used in Examples are as follows.

Component (A) (liquid rubber)

Liquid EPT: liquid ethylene-propylene terpolymer copolymer (product name PX-068 manufactured by Mitsui Chemicals, Inc.), SP value: 7.9 $cal/cm^3$
Liquid hydrogenated polybutadiene diacrylate (liquid saturated elastomer): product name SPBDA-S30 manufactured by Osaka Organic Chemical Industry Ltd., SP value: 8.1 $cal/cm^3$

Component (B) ((meth)acryloyl group-containing compound)

Isobornyl acrylate: product name Light Acrylate® IB-XA manufactured by Kyoei Kagaku Kogyo Co., Ltd.

Component (D) (photopolymerization initiator)

1-Hydroxy cyclohexyl phenyl ketone (product name IRGACURE® 184 manufactured by BASF SE, absorption wavelength: 254 nm) 2,2-Dimethoxy-1,2-diphenylmethan-1-one (product name IRGACURE® 651 manufactured by BASF SE, absorption wavelength: higher than 300 nm)
2,4,6-Trimethylbenzoyl-diphenyl-phosphine oxide (product name IRGACURE® TPO manufactured by BASF SE, absorption wavelength: higher than 300 nm)

Component (E) (filler)

Silica (fumed silica surface-treated with methacrylsilane): product name AEROSIL® R711 manufactured by Evonik Degussa GmbH
Binder-free titanium oxide paste: product name PECC-C01-06 manufactured by Peccell Technologies, Inc. Sensitizing dye solution: sensitizing dye ruthenium complex (product name N719 manufactured by Solaronix SA), solvent: acetonitrile and tert-butanol, concentration: 0.4 mM
In addition, 9,10-bis(methoxycarbonyloxy)anthracene (absorption wavelength: 350 to 450 nm, absorption waveband: 300 to 420 nm, having absorption peaks at 300, 365, 385, and 405 nm) as the component (C) and 9,10-bis(i-butoxycarbonyloxy)anthracene (absorption waveband: 300 to 420 nm, having absorption peaks at 300, 365, 385, and 405 nm) as the component (C) used in Examples were each synthesized as follows.

(Synthesis Example of 9,10-bis(methoxycarbonyloxy)anthracene)

To 15 mL of degassed toluene, 4.20 g (20.0 mmol) of 9,10-dihydroxyanthracene and 4.35 g (46.0 mmol) of methyl chlorocarbonate were added in a nitrogen atmosphere, and the mixture was cooled in ice water. Subsequently, a solution containing 4.65 g (46.0 mmol) of triethylamine dissolved therein was added to the obtained slurry. The precipitated hydrochloride of base was slowly stirred at 0°C for 10 hours as it was. Then, 40 mL of water was added thereto, and the precipitates were dissolved by well stirring to prepare two layers of toluene and water. Subsequently, the toluene layer was extracted, and 50 mL of methanol was added to the toluene layer, followed by concentration under reduced pressure. The precipitated crystals were filtered by suction and dried to obtain 3.70 g (11.3 mmol) of white fine crystals of 9,10-bis(methoxycarbonyloxy)anthracene.

(Synthesis Example of 9,10-bis(i-butoxycarbonyloxy)anthracene)

2.1 g (10.0 mmol) of 9,10-dihydroxyanthracene was reslurried in 15 g of degassed water in a nitrogen atmosphere. A solution containing 0.88 g (22.0 mmol) of sodium hydroxide dissolved in 3 g of water was added thereto. After a while, the 9,10-dihydroxyanthracene was dissolved to prepare a dark red aqueous solution of disodium of 9,10-dihydroxyanthracene. Subsequently, a solution containing 3.00 g (22.0 mmol) of i-butyl chlorocarbonate dissolved in 20 g of toluene was added to the obtained aqueous solution of disodium of 9,10-dihydroxyanthracene while cooled in ice water. The mixture was stirred for 5 hours after the addition so that the color of the solution disappeared to prepare colorless two layers. The aqueous layer was discarded, and the toluene layer was washed twice with 10 mL of water. Then, 40 mL of methanol was added thereto, followed by concentration. The precipitated crystals were filtered by suction and dried to obtain 2.60 g (6.35 mmol) of pale yellow crystals of 9,10-bis(i-butoxycarbonyloxy)anthracene.

(Synthesis Example of 9,10-bis(n-octanoyloxy)anthracene)

In a 300 ml three-neck flask equipped with a stirrer, 2.10 g (10.0 mmol) of 9,10-dihydroxyanthracene was slurried with 30 g of water in a nitrogen atmosphere, and a solution of 0.92 g (23.0 mmol) of sodium hydroxide in 2.5 g of water was added thereto to prepare an aqueous solution of disodium salt of 9,10-dihydroxyanthracene. To this aqueous solution, 20 mg of tetrabutyl ammonium bromide was added, and a solution of 3.58 g (22.0 mmol) of n-octanoyl chloride in 22 g of toluene was added over 30 minutes while cooled in ice water. The mixture was stirred for 4 hours after the addition to separate an aqueous layer. Subsequently, the toluene layer was washed three times with 20 ml of water, and 40 ml of methanol was then added thereto, followed by concentration. The precipitated crystals were dried to obtain 3.4 g (7.4 mmol) of white crystals of 9,10-bis(n-octanoyloxy)anthracene.

An organic solar cell was prepared as follows.

(1) Preparation of electrolyte solution

Lithium iodide (0.1 mol/L), t-butylpyridine (0.5 mol/L), and 1,2-dimethyl-3-propylimidazolium iodide (0.6 mol/L) were added to methoxyacetonitrile. The mixture was stirred for 1 hour by shaking using an ultrasonic cleaner and then left standing for 24 hours or longer in the dark to prepare an electrolyte solution.

(2) Preparation of dye solution

72 mg of a ruthenium complex dye (N719, manufactured by Solaronix SA) was placed in a 200 mL volumetric flask. 190 mL of dehydrated ethanol was mixed therewith, and the mixture was stirred. The volumetric flask was stoppered and then stirred for 60 minutes by shaking using an ultrasonic cleaner. The solution was kept at ordinary temperature, and the whole amount was then adjusted to 200 mL by the addition of dehydrated ethanol to prepare a dye solution.

(3) Conductive resin composition

3% by volume of conductive particles Micropearl AU (manufactured by Sekisui Jushi Corp., average particle diameter (median diameter): 8 μm) was added to the photocurable sealant composition shown in Table 1 and uniformly mixed using a planetary centrifugal mixer.

(4) Preparation of module

(a) Preparation of photoelectrode

A transparent conductive layer (indium tin oxide (ITO)) was stacked on a transparent substrate (polyethylene naphthalate film, thickness: 200 μm) to prepare a conductive electrode substrate (sheet resistance: 15 Ω/sq, transmittance: 0% @ 300 nm, 48% @ 395 nm). This substrate was print-coated with conductive silver paste (K3105, manufactured by Pelnox Ltd.) by the screen printing method at intervals appropriate for a photoelectrode cell width, and dried by heating for 15 minutes in a circulating hot air oven of 150°C to prepare a current collecting wire. The current collecting wire thus dried had a thickness of 8 μm.

A foundation layer was prepared by loading the conductive electrode substrate in a coater with the current collecting wire-formed surface up, and coating the substrate with ORGATIX PC-600 solution (manufactured by Matsumoto Fine Chemical Co., Ltd.) diluted into 1.6% at a sweep rate of 10 mm/sec using a wire bar, followed by drying at room temperature for 10 minutes and then further drying by heating at 150°C for 10 minutes. The foundation layer-formed

surface of the transparent conductive substrate with the foundation layer formed thereon was treated with laser at intervals appropriate for a photoelectrode cell width to form insulated wire.

A high-pressure mercury lamp (rated lamp wattage: 400 W) light source was placed at a distance of 10 cm from the mask pasting surface. Immediately after irradiation with electromagnetic wave for 1 minute, the surface was coated with binder-free titanium oxide paste (amount of the binder: less than 1%, PECC-AW1-01, manufactured by Peccell Technologies, Inc.) containing no polymer component using a Baker applicator. The paste was dried by heating for 10 minutes in a circulating hot air oven of 150°C to form a porous semiconductor fine particle layer (length: 60 mm, width: 5 mm).

Then, the conductive electrode substrate with the porous semiconductor fine particle layer (length: 60 mm, width: 5 mm) formed thereon was dipped in the prepared dye solution (40°C), and the dye was adsorbed thereonto with mild stirring. 90 minutes later, the dye-adsorbed titanium oxide film was taken out of the dye adsorption container, washed with ethanol, and dried to prepare a photoelectrode.

(b) Counter electrode

A metal mask punched to have an opening (length: 60 mm, width: 5 mm) was laminated onto the conductive surface of a conductive electrode substrate (sheet resistance: 150 Ω/sq) having a transparent conductive layer (indium tin oxide (ITO)) stacked on a transparent substrate (polyethylene naphthalate film, thickness: 200 μm). A platinum film pattern (catalyst layer) was formed by the sputtering method to obtain a counter electrode layer with a catalyst layer-formed part having light transmittance on the order of 72%. When the photoelectrode layer and the counter electrode layer were laminated such that their respective conductive surfaces faced each other, the titanium oxide pattern (porous semiconductor fine particle layer-formed part) and the platinum pattern (catalyst layer-formed part) had consistent structures.

(c) Preparation of organic solar cell

The counter electrode layer was fixed, with its catalyst layer-formed surface as a front side, onto an aluminum adsorption plate using a vacuum pump. The outer peripheral part of the titanium oxide layer was coated (such that the width and thickness of the encapsulant after bonding were 0.9 mm and 30 μm, respectively) with the photocurable sealant composition of Table 1 using a dispenser by an automatic coating robot. Also, a conductive resin composition for the conduction between the photoelectrode and the counter electrode was similarly applied over the silver wire part using s dispenser. Then, the titanium oxide layer pattern part was coated with a predetermined amount of the electrolyte solution prepared as described above. These layers were laminated at an inter-electrode distance of 30 μm in a reduced pressure environment using an automatic bonding apparatus so as to form a structure where the rectangular titanium oxide pattern and the same shape of the platinum pattern faced each other. Light irradiation (metal halide lamp temperature: 30°C, integrated light intensity: 3000 $mJ/cm^2$) was performed with a metal halide lamp from the photoelectrode side (the silver wire part became a light blocking part). Then, a plurality of elements disposed in the substrate after the bonding were each cut out, and conductive copper foil tape (CU7636D, manufactured by Sony Chemical & Information Device Corp.) was attached to the extraction electrode part to prepare a dye-sensitized solar cell (Z-type structure).

The sealant compositions of Examples and Comparative Examples were prepared according to the formulation shown in Table 1. Further, the adhesiveness and reliability (single sealant) of the sealant compositions were evaluated by the methods given below. The results are also shown in Table 1.

(Adhesiveness evaluation)

An electrolyte solution (electrolyte solution containing lithium iodide (0.1 mol/L), t-butylpyridine (0.5 mol/L), and 1,2-dimethyl-3-propylimidazolium iodide (0.6 mol/L) dissolved in methoxyacetonitrile) was added dropwise onto the ITO surface of ITO/PEN. Subsequently, each sealant composition was added dropwise onto the ITO surface of ITO/PEN damped with the electrolyte solution. The sealant composition was cured by irradiation with ultraviolet ray for 10 seconds using a high-pressure mercury lamp (270 $mW/cm^2$). In order to remove the electrolyte solution from the glass sheet, the ITO surface of ITO/PEN was washed with isopropanol. Then, the shape of the sealant composition on the ITO surface of ITO/PEN was observed and evaluated on the basis of the ratio of the residual area of the sealant composition according to the following criteria:

A: 90% or more of the sealant composition added dropwise adhered onto the electrode substrate.
B: 50% or more and less than 90% of the sealant composition added dropwise adhered onto the electrode substrate.
C: Less than 50% of the sealant composition added dropwise adhered onto the electrode substrate.

(Reliability evaluation)

In the evaluation of each prepared module, a pseudo-sunlight irradiation apparatus (AEL-0101-SH241SP, manufactured by Peccell Technologies, Inc.) light source was used. The light intensity was adjusted to 100,000 lux. Initial photoelectric conversion efficiency was measured, and conversion efficiency after 15 days at room temperature was measured. The maintenance rate of conversion efficiency was determined according to the expression given below to evaluate reliability. However, in Comparative Examples 1 and 2, evaluation was not conducted (-) because the cell itself was unable to be encapsulated.

Maintenance rate % = (Photoelectric conversion efficiency after 15 days at room temperature) / (Initial photoelectric conversion efficiency)

A: 85% or more
B: Less than 85%

[Table 1]

| | | | Example 1 | Example 2 | Example 3 | Example 4 | Example 5 | Example 6 | Example 7 | Example 8 | Example 11 | Example 12 | Comparative Example 1 | Comparative Example 2 | Comparative Example 3 |
|---|---|---|---|---|---|---|---|---|---|---|---|---|---|---|---|
| Formulation of photocurable sealant composition (parts by mass) | Component (A) | Liquid EPT | 100 | | | | | 100 | | 100 | 100 | | | | |
| | | SPBDA-S30 | | 100 | 100 | 100 | 100 | | 100 | | | 100 | 100 | | 100 |
| | Component (B) | Isobornyl acrylate | 80 | 80 | 80 | 80 | 80 | 80 | 80 | 80 | 80 | 80 | 80 | 100 | 80 |
| | Component (C) | 9,10-Bis(methoxycarbonyloxy)-anthracene | 0.5 | 0.5 | | 0.5 | 0.5 | 0.5 | 0.5 | 0.5 | 0.1 | 0.1 | | | |
| | | 9,10-Bis(i-butoxycarbonyloxy)-anthracene | | | 0.5 | | | | | | | | | | |
| | | 9,10-Bis(n-octanoyloxy)-anthracene | | | | | | | | | 0.5 | 0.5 | | | |
| | Component (D) | Irgacure 184 | 2 | 2 | 2 | | | 1 | 1 | | 1 | 1 | 2 | 2 | 1 |
| | | Irgacure 651 | | | | 2 | 1 | | | | | | | | |
| | | Irgacure TPO | | | | | 1 | 1 | 1 | 2 | | | | | 1 |
| | Component (E) | AEROSIL R711 | 0.5 | 0.5 | 0.5 | 0.5 | 0.5 | 0.5 | 0.5 | 0.5 | 0.5 | 0.5 | 0.5 | 0.5 | 0.5 |
| Evaluation | Adhesiveness | ITO/PEN substrate | B | A | A | A | A | A | A | B | A | A | C | C | B |
| | Reliability (maintenance rate) | Conversion efficiency after 15 days/initial conversion efficiency | B | B | B | B | A | B | A | B | B | A | - | - | C |

(Examples 1-4 and 8 to 12 are not claimed)

As shown in Table 2, solar cells having double sealants as shown in FIG. 2 were prepared using the photocurable sealant compositions of (not claimed) Examples 2, 4 and 8 (such that the width and thickness after bonding were 0.9 mm and 30 $\mu$m, respectively). Further, the reliability of the sealant compositions (double sealants) was evaluated by the method given below. The results are also shown in Table 2.

(Reliability evaluation)

Initial photoelectric conversion efficiency was measured, and conversion efficiency after 15 days and 30 days at room temperature was measured. The maintenance rate of conversion efficiency was determined according to the expression given below to evaluate reliability.

$$\text{Maintenance rate \%} = (\text{Photoelectric conversion efficiency after 15 days or 30 days at room temperature}) / (\text{Initial photoelectric conversion efficiency})$$

A: 85% or more

B: Less than 85%

[Table 2] (not claimed)

| | | | Example 9 | Example 10 |
|---|---|---|---|---|
| Photocurable sealant composition in first sealant | | | Photocurable sealant composition of Example 2 | Photocurable sealant composition of Example 2 |
| Photocurable sealant composition in second sealant | | | Photocurable sealant composition of Example 8 | Photocurable sealant composition of Example 4 |
| Evaluation | Reliability (maintenance rate) | Conversion efficiency after 15 days/initial conversion efficiency | A | A |
| | | Conversion efficiency after 30 days/initial conversion efficiency | B | A |

As shown in Table 1, in Comparative Examples 1 to 3 using the composition containing no component (C), adhesiveness was low. Particularly, in Comparative Examples 1 and 2, the cell itself was unable to be encapsulated. In Comparative Example 3, reliability was also low. By contrast, Examples 1 to 8, 11 and 12 (Examples 1-4 and 8-12 not claimed) resulted in excellent adhesiveness and also high reliability. Particularly, Examples 5 and 7 using two or more components (D) resulted in high reliability.

As shown in Table 2, in the case of the double sealant configuration, Examples 9 and 10 (not claimed) using a photopolymerization initiator having an absorption wavelength of 300 nm or lower and a fast curing rate in the sealant composition constituting the inner sealant produced excellent reliability.

INDUSTRIAL APPLICABILITY

The disclosure can provide a photocurable sealant composition capable of forming a sealant that exerts sufficient photocurability even at a light blocking part, is excellent in adhesiveness to a substrate, and has highly reliable sealing performance. The disclosure can provide an article comprising a sealant having highly reliable sealing performance. The disclosure can provide an organic solar cell having high reliability.

REFERENCE SIGNS LIST

1: Organic solar cell
11: First electrode substrate
12: Second electrode substrate
13: Substrate
14: Conductive layer
15: Light blocking member
16: Sealant
17: First surface
18: Second surface
19: Light blocking part
20: Silver wire
21: Conductive connection material
22: Electrolyte layer
23: Porous semiconductor fine particle layer
24: Catalyst layer
25: Second sealant
100: General series dye-sensitized solar cell
101: Photoelectrode substrate
102: Counter electrode substrate
103: Substrate
104: Conductive layer
105: Titanium oxide layer
106: Catalyst layer
107: Conductive connection material (gold-plated particles)
108: Sealant
109: Electrolyte solution
110: Light blocking part

## Claims

**1.** A photocurable sealant composition comprising:

(A) a liquid rubber, being in a liquid state at 23°C;
(B) a (meth)acryloyl group-containing compound;
(C) an aromatic sensitization aid capable of absorbing light having a wavelength of 300 nm or higher; and
(D) a photopolymerization initiator,

wherein the component (D) comprises two or more photopolymerization initiators differing in absorption wavelength;
wherein the component (A) is a liquid polymer having a cyclic olefin structure or a liquid saturated elastomer; and
wherein the liquid saturated elastomer is at least one member selected from the group consisting of hydrogenated polybutadiene, hydrogenated polyisoprene, a hydrogenated butadiene-isoprene copolymer and polyisobutylene.

**2.** The photocurable sealant composition according to claim 1, wherein an SP (Solubility Parameter) value of the component (A) is 6 to 9 $cal/cm^3$.

**3.** The photocurable sealant composition according to claim 1 or 2, wherein the component (A) is an ethylene-propylene terpolymer copolymer or a liquid saturated elastomer.

**4.** The photocurable sealant composition according to any one of claims 1 to 3, wherein the photocurable sealant composition comprises 10 to 200 parts by mass of the component (B) per 100 parts by mass of the component (A).

**5.** An article selected from the group consisting of a solar cell, a display, an electronic component, a coating material and an adhesive, comprising a cured product of a photocurable sealant composition according to any one of claims 1 to 4.

## Patentansprüche

1. Photohärtbare Dichtungszusammensetzung, umfassend:

   (A) einen flüssigen Kautschuk, der sich bei 23°C in einem flüssigen Zustand befindet;
   (B) eine (Meth)acryloylgruppen enthaltende Verbindung;
   (C) ein aromatisches Sensibilisierungshilfsmittel, das Licht mit einer Wellenlänge von 300 nm oder mehr absorbieren kann; und
   (D) einen Initiator für die Photopolymerisation,

   wobei die Komponente (D) zwei oder mehr Photopolymerisationsinitiatoren umfasst, die sich in der Absorptionswellenlänge unterscheiden;
   wobei die Komponente (A) ein flüssiges Polymer mit einer zyklischen Olefinstruktur oder ein flüssiges gesättigtes Elastomer ist; und
   wobei das flüssige gesättigte Elastomer mindestens ein Mitglied ist, das aus der Gruppe ausgewählt ist, die aus hydriertem Polybutadien, hydriertem Polyisopren, hydriertem Butadien-Isopren-Copolymer und Polyisobutylen besteht.

2. Photohärtbare Dichtungszusammensetzung nach Anspruch 1, wobei ein SP-Wert (Löslichkeitsparameter) der Komponente (A) 6 bis 9 cal/$cm^3$ beträgt.

3. Photohärtbare Dichtungszusammensetzung nach Anspruch 1 oder 2, wobei die Komponente (A) ein Ethylen-Propylen-Terpolymer-Copolymer oder ein flüssiges gesättigtes Elastomer ist.

4. Photohärtbare Dichtungszusammensetzung nach einem der Ansprüche 1 bis 3, wobei die photohärtbare Dichtungszusammensetzung 10 bis 200 Masseteile der Komponente (B) pro 100 Masseteile der Komponente (A) umfasst.

5. Gegenstand, ausgewählt aus der Gruppe bestehend aus einer Solarzelle, einer Anzeige, einem elektronischen Bauteil, einem Beschichtungsmaterial und einem Klebstoff, umfassend ein gehärtetes Produkt einer photohärtbaren Dichtungszusammensetzung nach einem der Ansprüche 1 bis 4.

## Revendications

1. Composition de matériau d'étanchéité photodurcissable comportant :

   (A) un caoutchouc liquide, étant dans un état liquide à 23 °C,
   (B) un composé contenant un groupe (méth)acryloyle,
   (C) une aide à la sensibilisation aromatique capable d'absorber de la lumière ayant une longueur d'onde de 300 nm ou plus, et
   (D) un initiateur de photopolymérisation,

   dans laquelle le composant (D) comporte deux initiateurs de photopolymérisation ou plus qui diffèrent en termes de longueur d'onde d'absorption,
   dans laquelle le composant (A) est un polymère liquide ayant une structure d'oléfine cyclique ou un élastomère saturé liquide, et
   dans laquelle l'élastomère saturé liquide est au moins un élément choisi parmi le groupe constitué de polybutadiène hydrogéné, de polyisoprène hydrogéné, d'un copolymère de butadiène-isoprène hydrogéné et de polyisobutylène.

2. Composition de matériau d'étanchéité photodurcissable selon la revendication 1, dans laquelle une valeur SP (paramètre de solubilité) du composant (A) est de 6 à 9 cal/$cm^3$.

3. Composition de matériau d'étanchéité photodurcissable selon la revendication 1 ou 2, dans laquelle le composant (A) est un copolymère terpolymère d'éthylène-propylène ou un élastomère saturé liquide.

4. Composition de matériau d'étanchéité photodurcissable selon l'une quelconque des revendications 1 à 3, dans laquelle la composition de matériau d'étanchéité photodurcissable comporte 10 à 200 parties en masse du composant (B) pour 100 parties en masse du composant (A).

**5.** Article choisi parmi le groupe constitué d’une cellule solaire, d’un affichage, d’un composant électronique, d’un matériau de revêtement et d’un adhésif, comportant un produit durci d’une composition de matériau d’étanchéité photodurcissable selon l’une quelconque des revendications 1 à 4.

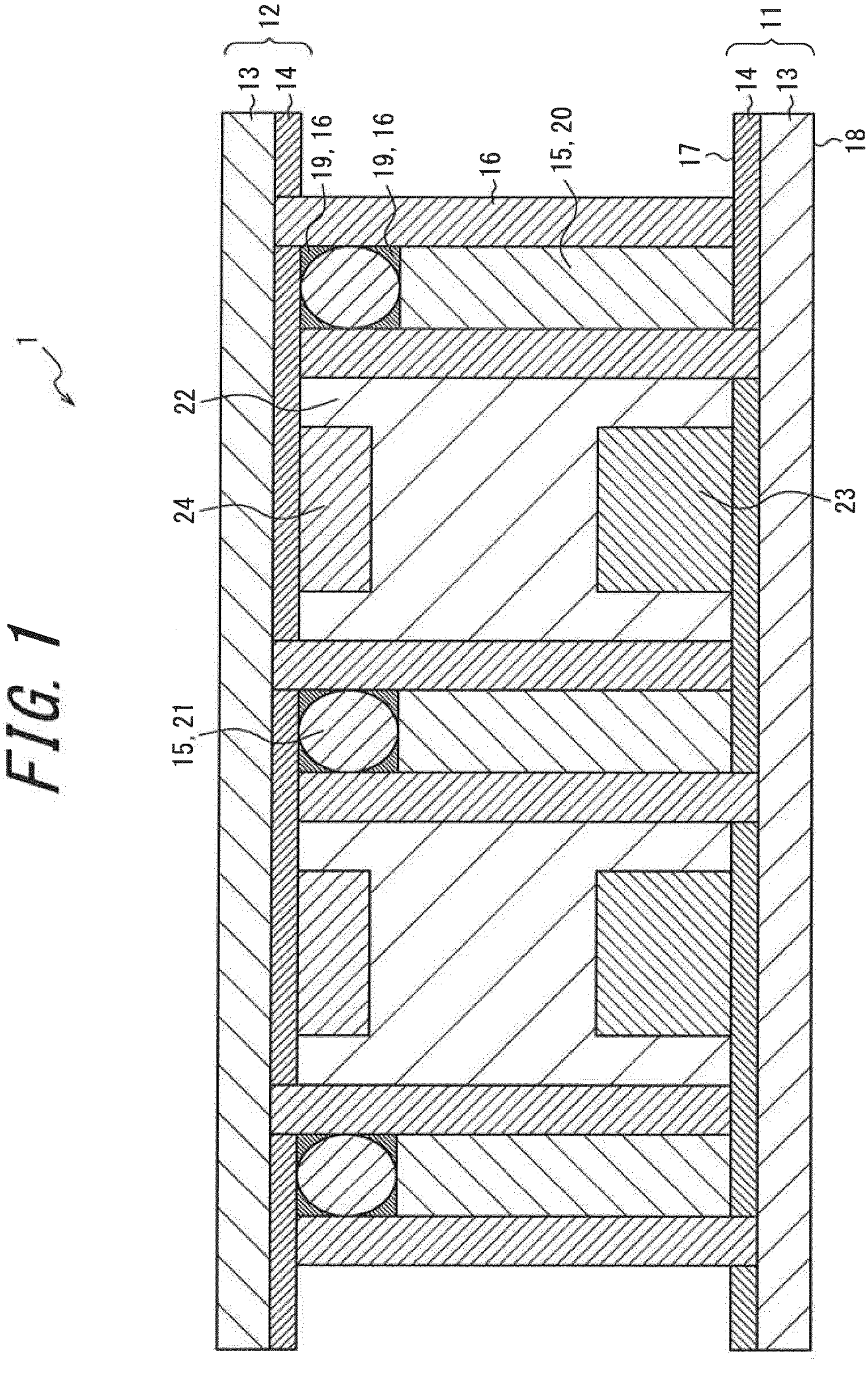


FIG. 1

FIG. 2

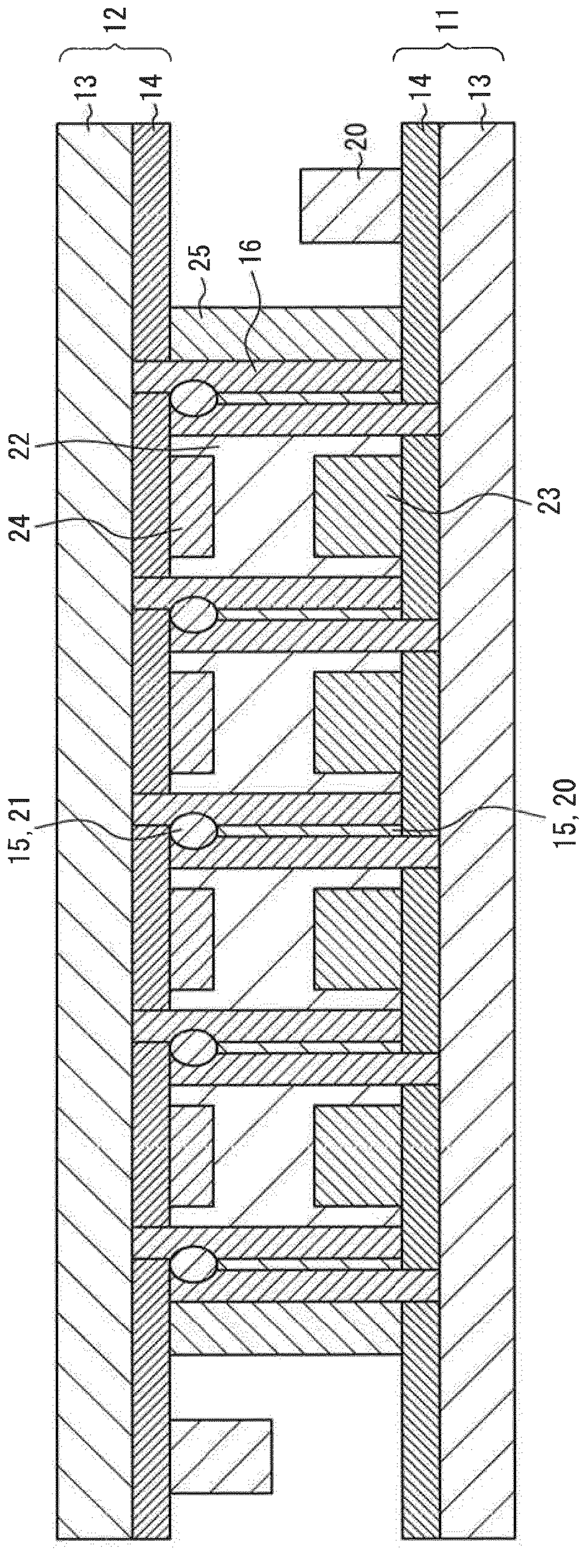

FIG. 3

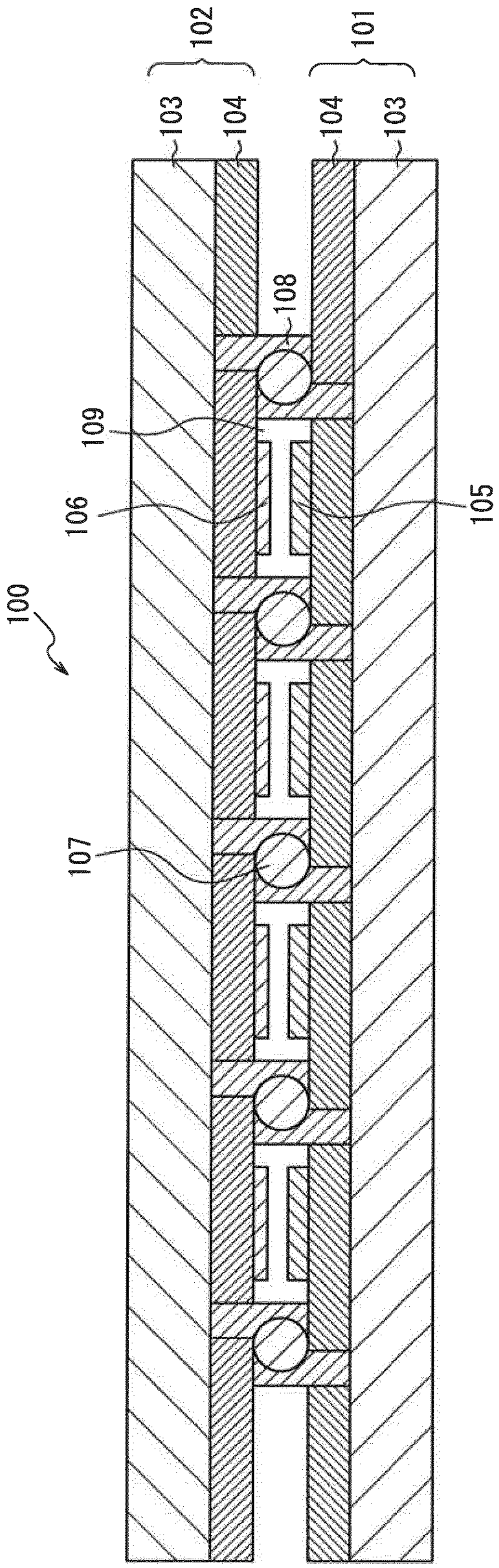

FIG. 4

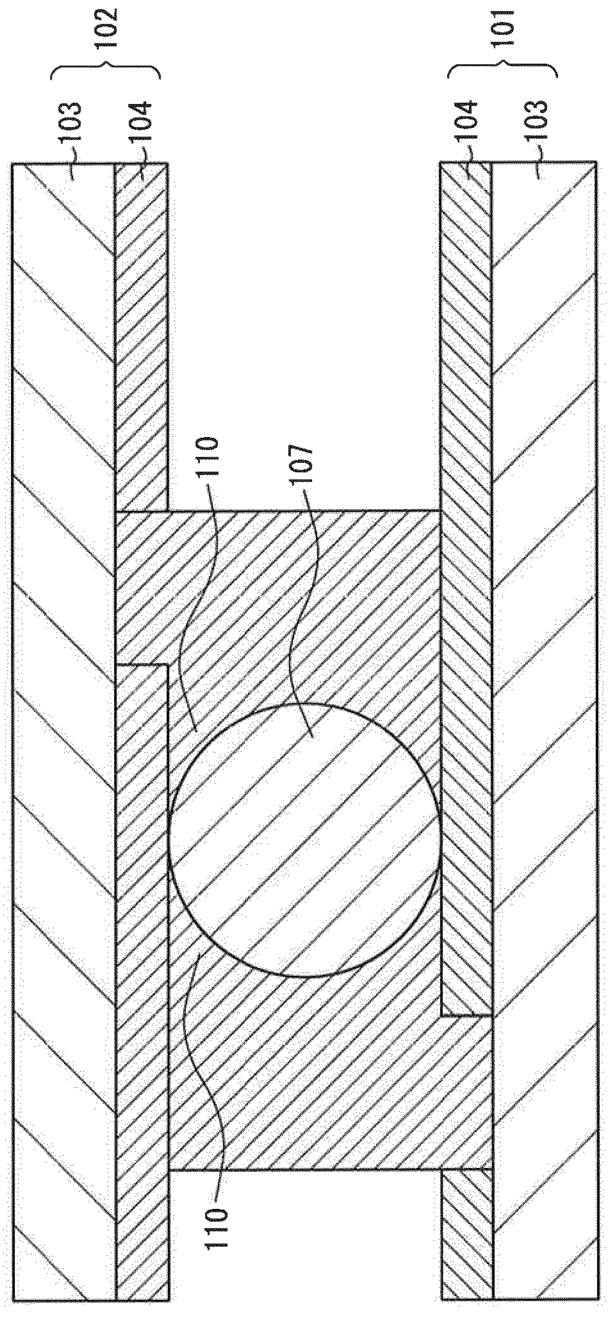

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2015134937 A
- JP 2010180258 A
- WO 2007046499 A
- WO 2006011655 A
- JP 2014049631 A
- JP 2015046583 A
- JP 2016009737 A
- JP 2006004827 A


### Non-patent literature cited in the description


- **SHIN PORIMA SEIZOU PUROSESU.** New Polymer Production Process in English. Kogyo Chosakai Publishing Co., Ltd, 309-330
- **NISHIKUBO, T. et al.** *Polym. J.,* 1994, vol. 26 (7), 864